# EUROPEAN PATENT SPECIFICATION

(11) **EP 4 629 758 B1**
(45) Date of publication and mention of the grant of the patent: **04.11.2026**
(21) Application number: 25197139.6
(22) Date of filing: 28.08.2020
(51) Int. Cl.: B23K 35/02, B23K 35/26, C22C 13/02, H05K 3/34, H05K 3/346

(54) **HIGH TEMPERATURE ULTRA-HIGH RELIABILITY ALLOYS**
HOCHTEMPERATUR-LEGIERUNGEN MIT ULTRAHOHER ZUVERLÄSSIGKEIT
ALLIAGES À HAUTE TEMPÉRATURE ET À TRÈS HAUTE FIABILITÉ

(30) Priority: 02.09.2019 IN 201911035248
(43) Date of publication of application: 08.10.2025
(60) Divisional application: 26203165.1 / 4 827 251
(62) Document number(s) of the earlier application(s) in accordance with Art. 76 EPC: 20771431.2 / 4 025 378
(73) Proprietor: Alpha Assembly Solutions Inc., Waterbury, CT 06702 (US)
(72) Inventor: CHOUDHURY, Pritha, Connecticut, 06702 (US); RIBAS, Morgana, Connecticut, 06702 (US); KUMAR, Anil, Connecticut, 06702 (US); RANGARAJU, Raghu, R., Connecticut, 06702 (US); SARKAR, Siuli, Connecticut, 06702 (US)
(74) Representative: Novagraaf Group

(56) References cited:
- JP-B2- 4 391 276
- US-A1- 2018 102 464
- SAYYADI REZA ET AL: "Physical and mechanical properties of synthesized low Ag/lead-free Sn-Ag-Cu-xBi (x?=?0, 1, 2.5, 5?wt%) solders", MATERIALS SCIENCE, ELSEVIER, AMSTERDAM, NL, vol. 735, 23 August 2018 (2018-08-23), pages 367 - 377, XP085477442, ISSN: 0921-5093, DOI: 10.1016/J.MSEA.2018.08.071

## Description

The present invention relates generally to the field of metallurgy, and more particularly to a solder alloy. The solder alloy is particularly, though not exclusively, suitable for use in electronic soldering applications such as wave soldering, surface mounting technology, hot air leveling and ball grid arrays, land grid arrays, bottom terminated packages, LEDs and chip scale packages.

Lead-free solders were initially developed due to environmental and health concerns, and as replacements for conventional soft solder alloys. Many conventional lead-free solder alloys are based around the Sn-0.7 wt.% Cu eutectic composition. The tin-silver-copper system has also been embraced by the electronics industry as a lead-free alternative for soldering materials. For example, the near-eutectic 96.5Sn3.0Ag0.5Cu, exhibits superior fatigue life compared to the eutectic Sn-Pb solder, while having melting point in the range of about 217 to 220 °C.

As use of lead-free soldering materials becomes widespread, either due to environmental directives or pressure from the end users, so does the range of applications for such materials. In some fields, such as automotive, high power electronics and energy, including LED lighting for example, it is desirable for solder alloys to operate at higher temperatures, for example at 150 °C or higher, for a relatively longer time. However, the 96.5Sn3.0Ag0.5Cu alloy does not perform well at such temperatures.

A number of attempts have been made to find better-performing alternatives to 96.5Sn3.0Ag0.5Cu. US10,376,994B2 relates to a soldering material based on Sn, Ag and Cu. US2016/0325384A1 relates to high reliability, lead-free solder alloys for harsh environment and electronic applications. EP3321025A1 relates to a lead-free solder alloy, a flux composition, a solder paste composition, an electronic circuit board and an electronic control device. US10,195,698B2 relates to lead-free, high reliability solder alloys. US10,300,562B2 relates to a solder alloy, a solder paste and an electronic circuit board. WO2019/094242A1 relates to a low-silver tin-based alternative solder alloy to Standard SAC alloys for high reliability applications. WO2019/094243A1 relates to a high reliability lead-free solder alloy for electronic applications in extreme environments. However, none of these alternatives provide a favourable combination of high temperature reliability and favourable mechanical properties. US2018102464A1 describes improved electrical and thermal properties of solder alloys achieved by the use of micro-additives in solder alloys to engineer the electrical and thermal properties of the solder alloys and the properties of the reaction layers between the solder and the metal surfaces. The electrical and thermal conductivity of alloys and that of the reaction layers between the solder and the metal surfaces can be controlled over a wide range of temperatures. The solder alloys produce stable microstructures wherein such stable microstructures of these alloys do not exhibit significant changes when exposed to changes in temperature, compared to traditional interconnect materials.

The present invention aims to solve at least some of the problems associated with the prior art or to provide a commercially acceptable alternative.

Accordingly, in a first aspect, the present invention provides a lead-free solder according to claim 1.

The present invention will now be further described. In the following passages different aspects of the invention are defined in more detail.

The term "solder alloy" used herein encompasses a fusible metal alloy with a melting point in the range of from 90 to 400 °C. The alloys are lead-free meaning that no lead is added intentionally. Thus, the lead content is zero or at no more than accidental impurity levels.

The solder alloy may exhibit improved high temperature reliability and may be capable of withstanding operational temperatures of typically at least 150 °C. The solder alloy may exhibit improved mechanical properties and high temperature creep resistance compared to the conventional 96.5SnAg3.0Cu0.5 alloy.

The solder alloy may have a high melting point, specifically a liquidus temperature above 210 °C and below 260 °C. The solder alloy preferably has a liquidus temperature of greater than 212 °C, more preferably greater than 215 °C, even more preferably greater than 218 °C, still even more preferably greater than 220 °C. A higher liquidus temperature may enable the alloy to be used in a higher temperature soldering process. The solder alloy preferably has a liquidus temperature of less than 250 °C, more preferably less than 240 °C, even more preferably less than 235 °C. Such liquidus temperatures may be advantageous because peak reflow temperatures are typically 25 to 30 °C above the liquidus temperature, and reflow temperatures higher than about 260 °C may lead to various issues during soldering, such as damaging printed circuit boards and components.

The solder alloy may exhibit favourable mechanical properties and favourable solderability. The solder alloy may exhibit superior high temperature creep properties and superior thermo-mechanical properties and fatigue life, such as those evaluated in thermal cycling or thermal shock tests covering a wide temperature range and long dwell times. The solder alloys may exhibit superior thermal cycling and/or thermal shock performance in harsh environmental conditions such as, for example, from -40 to 150 °C, with 30 minutes dwell time at each temperature.

The alloying additions are used to modify the alloy microstructure and, consequently, its properties due to physical metallurgy mechanisms such as precipitation strengthening, solid solution strengthening, grain refinement and diffusion control.

Advantageously, the magnitude of the mechanical properties of the solder alloy, such as hardness, tensile strength and high temperature creep, may be at least twice that of 96.5SnAg3.0Cu0.5. Bismuth, antimony and indium, for example, affect the solidus and or liquidus temperatures of the solder alloy. These elements also have high solid solubility in tin and thus may contribute significantly towards solid solution strengthening of the matrix. The changes in solidus or liquidus temperatures does not appear to affect adversely the mechanical properties of the alloys.

Diffusion-dependent creep deformation depends on the homologous temperature, i.e. ratio of the test temperature to melting temperature of the material in absolute scale. The homologous temperature of the solder alloy may be in the range of 0.84 to 0.86. The melting temperature of the solder alloy therefore has no significant effect on the mechanical properties.

An optimum combination of solid solution and precipitation strengthening may result in a distributed network of precipitate particles in a strong matrix. Precipitate particles may include, for example, Ag₃Sn and (Cu,Ni)₆Sn₅. The precipitate network resists the movement of grain boundaries during creep deformation, thus enhancing the creep strength.

The solder alloy comprises from 3 to 4 wt.% silver. The presence of silver in the specified amount may serve to improve mechanical properties, for example strength, through the formation of network-like intermetallic compounds such as, for example, Ag₃Sn. In addition, the presence of silver may improve wetting and spread. Higher levels of silver, in particular levels higher than 4.5 wt.% silver, may increase the liquidus temperature and larger precipitates of Ag₃Sn formed in the solder matrix act as sites of crack initiation and subsequent failure. Lower contents of silver may not form enough Ag₃Sn precipitates that may be helpful in improving the strength.

The solder alloy comprises from 3 to 4 wt.% bismuth. The presence of bismuth in the specified amount may serve to improve mechanical properties through solid solution strengthening. Bismuth may also act to improve creep resistance. Bismuth may also improve wetting and spread. However, bismuth addition in excess of the specified amount may result in precipitation of bismuth in tin resulting in a more brittle alloy.

The solder alloy comprises from 3 to 4 wt.% of antimony. In a preferred embodiment, the alloy comprises at least 3.1 wt.% antimony, even more preferably at least 3.2 wt.% antimony. The presence of antimony in the specified amount may serve to improve mechanical properties through solid solution strengthening. Antimony may also act to improve creep resistance and thermal fatigue resistance. Antimony may also increase the liquidus temperature of the alloy. Antimony addition lower than the specified range may not have the required improvement of mechanical strength and thermal fatigue resistance. Antimony additions higher than the specified range may increase the liquidus temperature such that the prescribed reflow temperature also increases. Reflow temperatures higher than 260 °C can lead to various issues during soldering, such as damaging printed circuit boards and components.

The solder alloy comprises from 0.5 to 0.8 wt.% of copper. The presence of copper in the specified amount may serve to improve mechanical properties, for example strength, through the formation of Cu-Sn intermetallic compounds. Copper addition in the specified range results in the optimum quantity of intermetallic compound precipitates required for strengthening the alloy.

In a reference example, the solder alloy optionally comprises up to 0.5 wt.% nickel, e.g. from 0.001 to 0.5 wt.%. The solder alloy preferably comprises nickel. The solder alloy preferably comprises from 0.001 to 0.4 wt.% nickel, more preferably from 0.01 to 0.3 wt.% nickel, even more preferably from 0.02 to 0.2 wt.% nickel. The presence of nickel in the specified amount may serve to improve mechanical properties through the formation of intermetallic compounds with tin and copper, which can result in precipitation strengthening. In addition, the presence of nickel may act to reduce the copper dissolution rate. Nickel may also increase thermal reliability by decreasing IMC growth at the substrate/solder interface.

In a reference example, the solder alloy optionally comprises up to 6 wt.% indium, e.g. from 0.001 to 6 wt.% indium. The solder alloy preferably comprises indium. The solder alloy preferably comprises from 0.001 to 5.5 wt.% indium, more preferably from 0.02 to 4 wt.% indium, even more preferably from 0.5 to 3 wt.% indium. The presence of indium in the specified amount may act to improve mechanical properties through solid solution and or precipitate strengthening. Addition of indium may also decrease the solidus and liquidus temperatures, with a greater effect at reducing the solidus temperature. Higher levels of indium may result in the formation of low temperature phases that will adversely affect the long-term reliability of the alloys.

In a reference example, the solder alloy optionally comprises up to 0.5 wt.% titanium, e.g. from 0.01 to 0.5 wt.% titanium. The solder alloy preferably comprises titanium. The solder alloy preferably comprises from 0.001 to 0.3 wt.% titanium, more preferably from 0.005 to 0.2 wt.% titanium, even more preferably from 0.007 to 0.05 wt.% titanium. The presence of titanium in the amounts specified may improve one or more of strength, solid state interfacial reactions and thermo-mechanical reliability.

In a reference example, the solder alloy optionally comprises up to 0.5 wt.% germanium, e.g. from 0.01 to 0.5 wt.% germanium. The solder alloy preferably comprises germanium. The solder alloy preferably comprises from 0.001 to 0.3 wt.% germanium, more preferably from 0.001 to 0.1 wt.% germanium, even more preferably from 0.001 to 0.02 wt.% germanium. The presence of germanium may act to improve mechanical properties through particle dispersion. Germanium may also help in deoxidation and may also improve wettability and solder joint strength and appearance. In addition, germanium in combination with nickel and/or titanium, may improve the thermo-mechanical fatigue properties.

The solder alloy comprises from 0.001 to 0.012 wt.% neodymium. The presence of rare earths (neodymium) may act to improve mechanical properties by particle dispersion and/or microstructure modification. Rare earths (neodymium) may act to improve spread and wettability.

In a reference example, the solder alloy optionally comprises up to 0.5 wt.% cobalt, for example from 0.001 to 0.5 wt.% cobalt. The solder alloy preferably comprises cobalt. The solder alloy preferably comprises from 0.01 to 0.2 wt.% cobalt, from preferably from 0.01 to 0.2 wt.% cobalt, even more preferably from 0.02 to 0.1 wt.% cobalt. The presence of cobalt in the specified amounts may improve the strength and/or high temperature properties of the solder. In a preferred embodiment, the alloy is "cobalt-free". This may be advantageous in view of the high cost of cobalt and the toxicity of cobalt.

In a reference example, the solder alloy optionally comprises up to 5 wt.% aluminium, e.g. from 0.001 to 5 wt.% aluminum. The solder alloy preferably comprises aluminum. The solder preferably comprises from 0.001 to 3 wt.%, more preferably from 0.005 to 2 wt.% of aluminum, even more preferably from 0.01 to 1.5 wt.% aluminum, still even more preferably from 0.015 to 1 wt.% aluminum, still more preferably from 0.02 to 0.08 wt.% aluminum. The presence of aluminum in the recited amounts may improve fatigue life of the solder.

In a reference example, the solder alloy optionally comprises up to 5 wt.% silicon, e.g. from 0.001 to 5 wt.% silicon. The solder alloy preferably comprises silicon. The solder alloy preferably comprises from 0.001 to 3 wt.% silicon, more preferably from 0.005 to 2 wt.% of silicon, even more preferably from 0.01 to 1.5 wt.% silicon, still even more preferably from 0.015 to 1 wt.% silicon, still more preferably from 0.02 to 0.08 wt.% silicon. The presence of silicon in the recited amounts may improve mechanical properties, fatigue life, and thermal and electrical conductivity of the solder.

In a reference example, the solder alloy optionally comprises one or more of: up to 0.5 wt.% chromium, preferably from 0.001 to 0.5 wt. % chromium; up to 0.5 wt.% manganese, preferably from 0.001 to 0.5 wt.% of manganese, more preferably from 0.003 to 0.015 wt.% manganese, even more preferably from 0.005 to 0.01 wt.% manganese; up to 0.5 wt.% iron, preferably from 0.01 to 0.5 wt.% of iron, more preferably from 0.01 to 0.1 wt.% iron, even more preferably from 0.015 to 0.035 wt.% iron or from 0.85 to 0.95 wt.% iron; up to 0.5 wt.% phosphorus, preferably from 0.001 to 0.5 wt.% of phosphorus; up to 0.5 wt.% gold, preferably from 0.001 to 0.5 wt.% of gold; up to 1 wt.% gallium, preferably from 0.01 to 0.9 wt.% gallium, more preferably from 0.2 to 0.8 wt.% of gallium, even more preferably 0.4 to 0.6 wt.% gallium; up to 0.5 wt.% tellurium, preferably from 0.001 to 0.5 wt.% of tellurium; up to 0.5 wt.% selenium, preferably from 0.001 to 0.5 wt.% of selenium; up to 0.5 wt.% calcium, preferably from 0.001 to 0.5 wt.% of calcium; up to 0.5 wt.% vanadium, preferably from 0.001 to 0.5 wt.% of vanadium; up to 0.5 wt.% molybdenum, preferably from 0.001 to 0.5 wt.% of molybdenum; up to 0.5 wt.% platinum, preferably from 0.001 to 0.5 wt.% of platinum; and up to 0.5 wt.% magnesium, preferably from 0.001 to 0.5 wt.% of magnesium. Aluminium, calcium, gallium, germanium, magnesium, phosphorus and vanadium may act as deoxidizers and may also improve wettability and solder joint strength. Other elemental additions, such as gold, chromium, iron, manganese, molybdenum, platinum, selenium and tellurium may act to improve strength and interfacial reactions. Aluminium in combination with silicon may act to improve strength and reliability performance of the alloys. Germanium in combination with silicon may also improve strength and reliability performance of the alloys.

In a reference example, the solder alloy preferably comprises from one to three elements, preferably one or two elements, more preferably two elements selected from nickel, titanium, germanium, indium, manganese, rare earths, cobalt, aluminium, silicon, chromium, iron, phosphorus, gold, gallium, tellurium, selenium, calcium, vanadium, molybdenum, platinum and magnesium, preferably selected from nickel, titanium, germanium, indium, manganese, rare earths, cobalt, silicon, iron and gallium. In a reference example, the solder alloy preferably comprises nickel and indium, or nickel and manganese, or nickel and germanium, or nickel, indium and neodymium, or nickel and titanium, or nickel and cerium, or indium, or indium, titanium and germanium, or nickel, or neodymium (present invention), or germanium, or silicon, or nickel and iron, or nickel and silicon, or nickel and cobalt, or cobalt and manganese, or manganese, or manganese and iron, or cobalt and germanium, or cobalt and titanium, or nickel and gallium, or indium and cobalt. Such an alloy may exhibit favourable mechanical properties.

In a reference example, the solder alloy preferably comprises nickel and one of titanium, germanium, indium, manganese, rare earths, cobalt, aluminium, silicon, chromium, iron, phosphorus, gold, gallium, tellurium, selenium, calcium, vanadium, molybdenum, platinum and magnesium, preferably selected from nickel, titanium, germanium, indium, manganese, rare earths, cobalt, silicon, iron and gallium, preferably one of titanium, germanium, manganese, cobalt and indium, more preferably one of titanium, germanium and manganese. Such an alloy may exhibit favourable mechanical properties.

The wt.% of antimony is greater than the wt.% of bismuth. Such an alloy may exhibit favourable mechanical properties, in particular a high strength. Since the bismuth content is also controlled to not exceed about 4 wt.%, the high strength may be combined with a low brittleness.

The sum of the wt.% of antimony and the wt.% of bismuth is preferably greater than or equal to 6.5, more preferably greater than or equal to 7.5. This may increase the strength of the alloy. When the sum of the wt.% of antimony and the wt.% of bismuth is controlled to be in the above amounts, together with also controlling the bismuth content to not exceed 4 wt.%, particularly favourable mechanical properties may be obtained. The reasoning is as follows. Bismuth has a maximum solubility of about 4 wt.%, while antimony has maximum solubility of 3 wt.% in Sn at room temperature. Antimony contributes to significant solid solution strengthening at least up to 150 °C. A greater strength-enhancing effect of antimony is obtained if the maximum solubility of bismuth is not exceeded. A bismuth content greater than about 4 wt.% may not lead to further increase in strength since excess bismuth precipitates, and may even be harmful for mechanical behavior by increasing the brittleness of the alloy.

In a reference example, the alloy consists of:
from 2.5 to 4 wt.% silver;
from 2.8 to 4.2 wt.% bismuth, preferably from 2.8 to 4 wt.% bismuth;
from 3.2 to 6.2 wt.% antimony;
from 0.4 to 0.8 wt.% copper;
from 0.04 to 0.18 wt.% nickel;
one of:
   from 0.007 to 0.05 wt.% titanium,
   from 0.001 to 0.02 wt.% germanium, and
   from 0.005 to 0.01 wt.% manganese; and
the balance tin together with any unavoidable impurities,
wherein:
   the wt.% of antimony is greater than the wt.% of bismuth, and
   the sum of the wt.% of antimony and the wt.% of bismuth is greater than or equal to 6.5.

Such an alloy may exhibit a particularly favourable combination of favourable mechanical properties, favourable solderability, superior high temperature creep properties and superior thermo-mechanical properties and fatigue life, such as those evaluated in thermal cycling or thermal shock tests covering a wide temperature range and long dwell times. In addition, such an alloy is "cobalt-free".

This may be advantageous in view of the high cost of cobalt and the toxicity of cobalt.

In another reference example, the solder alloy comprises:
from 3 to 5 wt.% silver;
from 0.01 to 0.2 wt.% bismuth;
from 4 to 6 wt.% antimony;
from 0.3 to 1 wt.% copper;
one or more of:
   up to 6 wt.% indium,
   up to 0.5 wt.% titanium,
   up to 0.5 wt.% germanium,
   up to 0.5 wt.% rare earths,
   up to 0.5 wt.% cobalt,
   up to 5.0 wt.% aluminium,
   up to 5.0 wt.% silicon,
   up to 0.5 wt.% manganese,
   up to 0.5 wt.% chromium,
   up to 0.5 wt.% iron,
   up to 0.5 wt.% phosphorus,
   up to 0.5 wt.% gold,
   up to 1 wt.% gallium,
   up to 0.5 wt.% tellurium,
   up to 0.5 wt.% selenium,
   up to 0.5 wt.% calcium,
   up to 0.5 wt.% vanadium,
   up to 0.5 wt.% molybdenum,
   up to 0.5 wt.% platinum,
   up to 0.5 wt.% magnesium; and
the balance tin together with any unavoidable impurities.

Such an alloy may exhibit a particularly favourable combination of favourable mechanical properties, favourable solderability, superior high temperature creep properties and superior thermo-mechanical properties and fatigue life, such as those evaluated in thermal cycling or thermal shock tests covering a wide temperature range and long dwell times. Such an alloy may be "nickel-free", i.e. it may contain nickel in no more than unavoidable impurity levels. This may be advantageous since nickel is toxic and is banned in certain jurisdictions for use in goods that come into contact with consumers. The alloy may consist of the recited elements.

The solder alloy preferably exhibits a solidus-liquidus temperature gap of less than 16 °C, preferably less than or equal to 14 °C, more preferably less than or equal to 12 °C. A too large solidus-liquidus temperature gap may lead to soldering defects due to the mushy zone formed before the complete solidification of the solder.

The solder alloy is preferably in the form of a bar, a stick, a solid or flux cored wire, a foil or strip, a film, a preform, a powder or paste (powder plus flux blend), solder spheres for use in ball grid array joints, a pre-formed solder piece or a reflowed or solidified solder joint, pre-applied on any solderable material such as a copper ribbon for photovoltaic applications or a printed circuit board of any type.

It will be appreciated that the alloys described herein may contain unavoidable impurities, although, in total, in an amount of not more than 1 wt.% of the composition. Preferably, the solder alloys contain unavoidable impurities in an amount of not more than 0.5 wt.% of the composition, more preferably not more than 0.3 wt.% of the composition, still more preferably not more than 0.1 wt.% of the composition, still more preferably not more than 0.05 wt.% of the composition, and most preferably not more than 0.02 wt.% of the composition.

The solder alloys described herein consist of the recited elements.

The alloys of the present invention may be manufactured by mixing the corresponding pure elements, or by mixing premade alloys, in any form factor, and by using any manufacturing method, if their final compositions are covered by the specification described herein.

In a reference example, the alloy consists of from 2.8 to 3.2 wt.% silver, from 2.8 to 3.2 wt.% bismuth, from 4.5 to 5.5 wt.% antimony, from 0.3 to 0.8 wt.% copper, from 0.08 to 0.2 wt.% nickel, 0.001 to 0.01 wt.% of germanium, and the balance tin together with unavoidable impurities. Such an alloy may exhibit a particularly favourable combination of favourable mechanical properties, favourable solderability, superior high temperature creep properties and superior thermo-mechanical properties and fatigue life, such as those evaluated in thermal cycling or thermal shock tests covering a wide temperature range and long dwell times.

In a reference example, the alloy consists of from 2.8 to 3.2 wt.% silver, from 2.8 to 3.2 wt.% bismuth, from 5.5 to 6.5 wt.% antimony, from 0.3 to 0.8 wt.% copper, from 0.08 to 0.2 wt.% nickel, 0.005 to 0.02 wt.% of titanium, and the balance tin together with unavoidable impurities. Such an alloy may exhibit a particularly favourable combination of favourable mechanical properties, favourable solderability, superior high temperature creep properties and superior thermo-mechanical properties and fatigue life, such as those evaluated in thermal cycling or thermal shock tests covering a wide temperature range and long dwell times.

In a reference example, the alloy consists of from 3.1 to 3.7 wt.% silver, from 3 to 3.5 wt.% bismuth, from 3 to 3.8 wt.% antimony, from 0.4 to 0.9 wt.% copper, from 0.01 to 0.9 wt.% nickel, from 0.001 to 0.01 wt.% of germanium, and the balance tin together with unavoidable impurities.

In a reference example, the alloy consists of from 3.2 to 3.9 wt.% silver, from 3.5 to 4.5 wt.% bismuth, from 5.5 to 6.5 wt.% antimony, from 0.3 to 0.9 wt.% copper, from 0.05 to 0.12 wt.% nickel, 0.001 to 0.01 wt.% of manganese, and the balance tin together with unavoidable impurities. Such an alloy may exhibit a particularly favourable combination of favourable mechanical properties, favourable solderability, superior high temperature creep properties and superior thermo-mechanical properties and fatigue life, such as those evaluated in thermal cycling or thermal shock tests covering a wide temperature range and long dwell times.

In a reference example, the alloy consists of from 3.5 to 4.2 wt.% silver, from 0.01 to 0.1 wt.% bismuth, from 5 to 6 wt.% antimony, from 0.4 to 0.9 wt.% copper, from 0.001 to 0.01 wt.% of germanium, from 0.2 to 0.8 wt.% indium, from 0.02 to 0.08 wt.% cobalt and the balance tin together with unavoidable impurities. Such an alloy may exhibit a particularly favourable combination of favourable mechanical properties, favourable solderability, superior high temperature creep properties and superior thermo-mechanical properties and fatigue life, such as those evaluated in thermal cycling or thermal shock tests covering a wide temperature range and long dwell times.

In a reference example,the alloy comprises from 3 to 4 wt.% silver, from 1 to 3 wt.% antimony, from 2 to 4 wt.% bismuth, from 0.3 to 1 wt.% copper, from 0.1 to 0.25 wt.% nickel, from 0.5 to 3.5 wt.% indium, and the balance tin together with unavoidable impurities. Such an alloy has a melting range of from 202.8 to 217.9°C, which is lower than the near eutectic temperature of the conventional 96.5Sn3.0Ag0.5Cu alloy. Such an alloy has a hardness and tensile strength that is about twice the magnitude of the hardness of 96.5Sn3.0Ag0.5Cu. The creep rupture time is 2.5 times that of 96.5Sn3.0Ag0.5Cu. In one specific example of this reference example, the alloy comprises approximately 3 wt.% silver, approximately 3.1 wt.% bismuth, approximately 2.1 wt.% antimony, approximately 0.8 wt.% copper, approximately 0.25 wt.% nickel, approximately 3.3 wt.% indium and the balance tin together with unavoidable impurities.

In a reference example, the alloy comprises 3 to 4.5 wt.% silver, 1 to 3 wt.% antimony, 2.5 to 4 wt.% bismuth, 0.5 to 1.5 wt.% copper, 0.1 to 0.25 wt.% nickel, 0.5 to 1.5 wt.% indium, and the balance tin together with unavoidable impurities. Such an alloy has a melting range of from 209.7 to 223.5°C and a hardness that is about twice the magnitude of the hardness of 96.5SnAg3.0Cu0.5. The creep rupture time of this alloy is 2.5 times that of 96.5Sn3.0Ag0.5Cu. In one specific example of this reference example, the alloy comprises approximately 3 wt.% silver, 3.1 wt.% bismuth, 2.1 wt.% antimony, 0.75 wt.% copper, 0.2 wt.% nickel, 1.2 wt.% indium, and the balance tin together with unavoidable impurities.

In a reference example, the alloy comprises 3 to 4.5 wt.% silver, 2 to 4 wt.% bismuth, 3.5 to 6.5 wt.% antimony, 0.5 to 1.5 wt.% copper, 0.05 to 0.2 wt.% nickel, and the balance tin together with unavoidable impurities. Such an alloy has a melting range of 203.3 to 236.1°C and tensile strength and creep rupture time that is more than twice that of 96.5Sn3.0Ag0.5Cu. In one specific example of this reference example, the alloy comprises approximately 3.6 wt.% silver, 3.9 wt.% bismuth, 4 wt.% antimony, 0.7 wt.% copper, 0.1 wt.% nickel, and the balance tin together with unavoidable impurities.

In a reference example, the alloy comprises 3 to 4 wt.% silver, 3 to 4.5 wt.% bismuth, 5 to 6.5 wt.% antimony,0.5 to 1 wt.% copper, 0.05 to 0.2 wt.% nickel, 0.001 to 0.01 wt.% of manganese, and the balance tin together with unavoidable impurities. In this reference example, the alloy preferably consists of from 3.2 to 4 wt.% silver, from 3.5 to 4.5 wt.% bismuth, from 5.5 to 6.5 wt.% antimony, from 0.3 to 0.09 wt.% copper, from 0.05 to 0.12 wt.% nickel, 0.001 to 0.01 wt.% of manganese, and the balance tin together with unavoidable impurities. Such an alloy has a melting range from 197.4 to 231.6°C. In one specific example of this reference example, the alloy comprises approximately 3.5 wt.% silver, 4.2 wt.% bismuth, 6.1 wt.% antimony, 0.7 wt.% copper, 0.1 wt.% nickel, 0.005 wt.% manganese, and the balance tin together with unavoidable impurities.

In a reference example, the alloy comprises 3 to 4 wt.% silver, 3 to 4 wt.% bismuth, 3.5 to 4.5 wt.% antimony, 0.3 to 0.8 wt.% copper, 0.02 to 0.3 wt.% nickel, 0.001 to 0.002 wt.% germanium, and the balance tin together with unavoidable impurities. Such an alloy has a melting range from 211.4 to 225.5⁰C. Such an alloy has more than twice the tensile strength and creep rupture time as that of 96.5Sn3.0Ag0.5Cu. In one specific example of this reference example, the alloy comprises 3.2 wt.% silver, 3.4 wt.% bismuth, 0.5 wt.% copper, 3.9 wt.% antimony, 0.15 wt.% nickel, 0.001 germanium, and the balance tin together with unavoidable impurities.

In a reference example, the alloy comprises 3 to 4 wt.% silver, 2.5 to 3.5 wt.% bismuth, 4 to 5.5 wt.% antimony, 0.3 to 0.8 wt.% copper, 0.1 to 0.2 wt.% nickel, 0.001 to 0.002 wt.% germanium, and the balance tin together with unavoidable impurities. Such an alloy has a melting range from 215.2 to 228.3⁰C. Such an alloy has more than twice the tensile strength as that of 96.5Sn3.0Ag0.5Cu. The creep rupture time of such an alloy is four times that of 96.5Sn3.0Ag0.5Cu. In one specific example of this reference example, the alloy comprises approximately 3.2 wt.% silver, 3 wt.% bismuth,0.5 wt.% copper, 4.9 wt.% antimony, 0.15 wt.% nickel, 0.001 wt.% germanium, and the balance tin together with unavoidable impurities.

In a reference example, the alloy comprises 3 to 4 wt.% silver, 3 to 4 wt.% bismuth, 0.3 to 0.8 wt.% copper, 3 to 4 wt.% indium, 5.5 to 6.5 wt.% antimony, 0.03 to 0.1 wt.% nickel, 0 to 0.005 wt.% some rare earth element (preferably neodymium) and the balance tin together with unavoidable impurities. Such an alloy has a melting range from 186.9 to 232.9°C. Such an alloy has more than thrice the tensile strength and four times the creep strength of 96.5Sn3.0Ag0.5Cu. In one specific example of this reference example, the alloy comprises 3.5 wt.% silver, 3.7 wt.% bismuth, 0.55 wt.% copper, 3.4 wt.% indium, 6.1 wt.% antimony, 0.06 wt.% nickel, 0.002 neodymium, and the balance tin together with unavoidable impurities.

In a reference example, the alloy comprises 3 to 4 wt.% silver, 2.5 to 4 wt.% bismuth,0.3 to 0.8 wt.% copper, 5 to 6.5 wt.% antimony, 0.1 to 0.2 wt.% nickel, 0.001 to 0.01 wt.% titanium, and the balance tin together with unavoidable impurities. Such an alloy has a melting range from 202.5 to 234.5°C. The tensile strength of such an alloy is more than twice and the creep rupture time is six times more than that of 96.5Sn3.0Ag0.5Cu. In one specific example of this reference example, the alloy comprises 3.2 silver, 3 bismuth, 0.5 wt.% copper, 5.9 antimony, 0.15 wt.% nickel, 0.006 wt.% titanium, and the balance tin together with unavoidable impurities.

In a reference example, the alloy comprises 3 to 4 wt.% silver, 3 to 4 wt.% bismuth, 0.5 to 1 wt.% copper, 1 to 2 wt.% indium, 5.5 to 6.5 wt.% antimony, 0.18 to 0.25 wt.% nickel, and the balance tin together with unavoidable impurities. Such an alloy has a melting range from 214.3 to 228.4°C. Such an alloy has twice the tensile strength and four times the creep rupture time than that of 96.5Sn3.0Ag0.5Cu. In one specific example of this reference example, the alloy comprises approximately 3.1 wt.% silver, 3.1 wt.% bismuth, 0.7 wt.% copper, 1.15 wt.% indium, 6.1 wt.% antimony, 0.25 wt.% nickel, and the balance tin together with unavoidable impurities.

In a reference example, the alloy comprises 3 to 4 wt.% silver,3 to 4 wt.% bismuth,0.5 to 1 wt.% copper, 5.5 to 6.5 wt.% antimony, 0.2 to 0.3 wt.% nickel, and the balance tin together with unavoidable impurities. Such an alloy has a melting range from 214 to 230.4°C. Such an alloy has twice the tensile strength and more than three times the creep strength than that of 96.5Sn3.0Ag0.5Cu. In one specific example of this reference example, the alloy comprises approximately 3.5 wt.% silver, 3.5 wt.% bismuth, 0.7 wt.% copper, 6.2 wt.% antimony, 0.3 wt.% nickel, and the balance tin together with unavoidable impurities.

In a reference example, the alloy comprises 3 to 4 wt.% silver,3 to 4 wt.% bismuth, 0.4 to 0.7 wt.% copper, 2.5 to 3.5 wt.% indium, 5.5 to 6.5 wt.% antimony, and the balance tin together with unavoidable impurities. Such an alloy has a melting range from 195.3 to 229.3^{O}C. Such an alloy has more than three times the tensile strength and more than four times the creep rupture time than that of 96.5Sn3.0Ag0.5Cu. In one specific example of this reference example, the alloy comprises approximately 3.5 wt.% silver, 3.7 wt.% bismuth, 0.5 wt.% copper, 3.4 wt.% indium, 6.1 wt.% antimony, and the balance tin together with unavoidable impurities.

In a reference example, the alloy comprises 3 to 4 wt.% silver, 3 to 4 wt.% bismuth, 0.4 to 0.6 wt.% copper, 2.5 to 3.5 wt.% indium, 5.5 to 6.5 wt.% antimony, 0.001 to 0.01 wt.% titanium, 0.0008 to 0.002 wt.% germanium, and the balance tin together with unavoidable impurities. Such an alloy has a melting range from 186.5 to 232.5 °C. Such an alloy has a tensile strength three times and creep rupture time three times that of 96.5Sn3.0Ag0.5Cu. In one specific example of this reference example, the alloy comprises approximately 3.5 wt.% silver, 3.8 wt.% bismuth, 0.5 wt.% copper, 3.4 wt.% indium, 6.1 wt.% antimony, 0.006 wt.% titanium, 0.001 wt.% germanium, and the balance tin together with unavoidable impurities.

In a reference example, the alloy comprises 3 to 4 wt.% silver, 3 to 4 wt.% bismuth, 0.5 to 0.8 wt.% copper, 3 to 4 wt.% antimony, 0.05 to 0.1 wt.% nickel, 0.001 to 0.002 wt.% germanium, and the balance together with unavoidable impurities. Such an alloy has a melting range from 198.9 to 230.9 °C. Such an alloy has more than two times the tensile strength and three times the creep rupture strength than that of 96.5Sn3.0Ag0.5Cu. In one specific example of this reference example, the alloy comprises approximately 3.6 wt.% silver, 3.9 wt.% bismuth, 0.7 wt.% copper, 3.9 wt.% antimony, 0.09 wt.% nickel, 0.001 wt.% germanium, and the balance tin together with unavoidable impurities.

In a reference example, the alloy comprises 3 to 4 wt.% silver, 3 to 4 wt.% bismuth, 0.5 to 0.8 wt.% copper, 3 to 4 wt.% antimony, 0.03 to 0.08 wt.% nickel,0.01 to 0.03 wt.% titanium, and the balance tin with unavoidable impurities. Such an alloy has a melting range from 198.9 to 227.6 °C. Such an alloy has twice the tensile strength and more than three times the creep rupture time than that of 96.5Sn3.0Ag0.5Cu. In one specific example of this reference example, the alloy comprises approximately 3 wt.% silver, 3.2 wt.% bismuth, 0.7 wt.% copper, 3.5 wt.% antimony, 0.06 wt.% nickel, 0.02 wt.% titanium, and the balance tin together with unavoidable impurities.

In a reference example, the alloy comprises 2.5 to 3.5 wt.% silver, 2.5 to 3.5 wt.% bismuth, 0.3 to 0.6 wt.% copper, 5.5 to 6.5 wt.% antimony, 0.01 to 0.04 wt.% nickel,0.01 to 0.03 wt.% titanium, and the balance tin together with unavoidable impurities. Such an alloy has a melting range from 202.6 to 229.2 °C. Such an alloy has more than thrice the tensile strength and more than six times the creep rupture strength than that of 96.5Sn3.0Ag0.5Cu. In one specific example of this reference example, the alloy comprises approximately 3 wt.% silver, 3.2 wt.% bismuth, 0.5 wt.% copper, 6.1 wt.% antimony, 0.03 wt.% nickel, 0.02 wt.% titanium, and the balance tin together with unavoidable impurities.

In a reference example, the alloy comprises 2.5 to 3.5 wt.% silver, 2.5 to 3.5 wt.% bismuth, 0.3 to 0.6 wt.% copper, 5.5 to 6.5 wt.% antimony, 0.001 to 0.015 wt.% nickel,0.015 to 0.035 wt.% titanium, and the balance tin together with unavoidable impurities. Such an alloy has a melting range from 203.3 to 229.7 °C. Such an alloy has more than thrice the tensile strength and more than six times the creep rupture strength than that of 96.5Sn3.0Ag0.5Cu. In one specific example of this reference example, the alloy comprises approximately 3 wt.% silver, 3.2 wt.% bismuth, 0.5 wt.% copper, 6.1 wt.% antimony, 0.01 wt.% nickel, 0.03 wt.% titanium, and the balance tin together with unavoidable impurities.

In a reference example, the alloy comprises 3 to 4 wt.% silver, 3 to 4 wt.% bismuth, 0.4 to 0.8 wt.% copper, 3 to 4 wt.% antimony, 0.03 to 0.05 wt.% titanium, 0.005 to 0.01 wt.% germanium, and the balance tin together with unavoidable impurities. Such an alloy has a melting range from 203.8 to 226.5 °C. Such an alloy has more than twice the tensile strength and four times the creep rupture strength than that of 96.5Sn3.0Ag0.5Cu. In one specific example of this reference example, the alloy comprises approximately 3.4 wt.% silver, 3.5 wt.% bismuth, 0.7 wt.% copper, 3.4% antimony, 0.002 titanium, 0.007 germanium, and the balance tin together with unavoidable impurities.

In a reference example, the alloy comprises 3 to 4 wt.% silver, 3 to 4 wt.% bismuth, 0.5 to 0.8 wt.% copper, 4.5 to 5.5 wt.% antimony, 0.09 to 0.15 wt.% nickel, 0.02 to 0.05 wt.% titanium, 0.0008 to 0.0014 wt.% germanium, and the balance tin together with unavoidable impurities. In one specific example of this reference example, the alloy comprises approximately 3 wt.% silver, 3.1 wt.% bismuth, 0.7 wt.% copper, 5.1 wt.% antimony, 0.14 wt.% nickel, 0.04 wt.% titanium, 0.001 wt.% germanium, and the balance tin together with unavoidable impurities.

The alloy according to the present invention comprises 3 to 4 wt.% silver, 3 to 4 wt.% bismuth, 0.5 to 0.8 wt.% copper, 3 to 4 wt.% antimony, 0.001 to 0.012 wt.% neodymium, and the balance tin together with unavoidable impurities. Such an alloy has a melting range from 210.8 to 224.5°C. Such an alloy has nearly four times the creep strength of 96.5Sn3.0Ag0.5Cu. In one specific example of this embodiment, the alloy comprises approximately 3.5 wt.% silver, 3.1 wt.% bismuth, 0.7 wt.% copper, 3.8 wt.% antimony, 0.005 wt.% neodymium, and the balance tin together with unavoidable impurities.

In a reference example, the alloy comprises 3 to 4 wt.% silver, 3 to 4 wt.% bismuth, 3 to 4 wt.% antimony, 0.4 to 0.7 wt.% copper, 0.02 to 0.07 wt.% nickel, 0.001 to 0.005 wt.% germanium, and the balance tin together with unavoidable impurities. Such an alloy has melting range from 202.9 to 224.6 °C. Such an alloy has 2.5 times the creep strength as that of 96.5Sn3.0Ag0.5Cu. In one such specific example of this reference example, the alloy comprises approximately, 3.5 wt.% silver, 4.16 wt.% bismuth, 3.9 wt.% antimony, 0.5 wt.% copper, 0.06 wt.% nickel, 0.001 wt.% germanium, and the balance tin together with unavoidable impurities.

In a reference example, the alloy comprises 3 to 4 wt.% silver, 3 to 4 wt.% bismuth, 4 to 6 wt.% antimony,0.4 to 0.7 wt.% copper, 2.5 to 3.5 wt.% indium, and the balance tin together with unavoidable impurities. Such an alloy has melting range from 195.8 to 228.6⁰C. Such an alloy has two times the creep strength as that of 96.5Sn3.0Ag0.5Cu. In one specific example of this reference example, the alloy comprises approximately, 3.8 wt.% silver, 4.2 wt.% bismuth, 4.7 wt.% antimony, 0.5 wt.% copper, 3.2 wt.% indium, and the balance tin together with unavoidable impurities.

In a reference example, the alloy comprises 3 to 4 wt.% silver, 1 to 2 wt.% bismuth, 1 to 2 wt.% copper, 3 to 4 wt.% antimony, 0.008 to 0.02 wt.% aluminum, 0.005 to 0.01 wt.% silicon, and the balance tin together with unavoidable impurities. Such an alloy has a melting range of 217.52 to 227.05 °C. In one specific example of this reference example, the alloy comprises approximately 3.8 wt.% silver, 1.6 wt.% bismuth, 1.3 wt.% copper, 4 wt.% antimony, 0.015 wt.% aluminum, 0.007 wt.% silicon, and the balance tin together with unavoidable impurities.

In a reference example, the alloy comprises 3 to 4 wt.% silver, 3 to 4 wt.% bismuth, 3 to 4 wt.% antimony, 0.5 to 0.8 wt.% copper, 0.03 to 0.06 wt.% nickel, 0.001 to 0.008 wt.% germanium, and the balance tin together with unavoidable impurities. Such an alloy has melting range from 212.8 to 224.5 °C. In one specific example of this reference example, the alloy comprises approximately, 3.4 wt.% silver, 3.3 wt.% bismuth, 0.6 wt.% copper, 3.4 wt.% antimony, 0.05 wt.% nickel and 0.001 wt.% germanium.

In a reference example, the alloy comprises 3 to 4 wt.% silver, 3.5 to 5 wt.% bismuth, 0.5 to 0.8 wt.% copper, 1 to 3 wt.% antimony, 0.1 to 0.2 wt.% nickel and 0.01 to 0.02 wt.% iron, and the balance tin together with any unavoidable impurities. Such an alloy has melting range from 209.9 to 221.2 °C. Such an alloy has three times the creep strength of 96.5Sn3.0Ag0.5Cu. In one specific example of this reference example, the alloy comprises approximately, 3.4 wt.% silver, 4.1 wt.% bismuth, 0.7 wt.% copper, 2.1 wt.% antimony, 0.2 wt.% nickel, 0.02 wt.% iron and the balance tin together with unavoidable impurities.

In a reference example, the alloy comprises 3.5 to 4 wt.% silver, 0.02 to 1 wt.% bismuth, 0.5 to 0.7 wt.% copper, 0.1 to 1 wt.% indium, 4.5 to 6 wt.% antimony, 0.03 to 0.1 wt.% nickel, and the balance tin together with unavoidable impurities.

Such an alloy has a melting range from 222.6 to 232.3 °C. Such an alloy has more than seven times the creep rupture strength as that of 96.5Sn3.0Ag0.5Cu. In one specific example of this reference example, the alloy comprises approximately, 3.8 wt.% silver, 0.06 wt.% bismuth, 0.6 wt.% copper, 0.6 wt.% indium, 5.3 wt.% antimony, 0.06 wt.% nickel, and the balance tin with unavoidable impurities.

In a reference example, the alloy comprises 3 to 4 wt.% silver, 2.8 to 3.8 wt.% bismuth, 0.5 to 0.8 wt.% copper, 3.5 to 4.5 wt.% antimony, 0.02 to 0.1 wt.% nickel, 0.01 to 0.025 wt.% silicon, and the balance tin together with unavoidable impurities. Such an alloy has a melting range from 214.4 to 225.6 °C. In one specific example of this reference example, the alloy comprises approximately, 3.5 wt.% silver, 3.1 wt.% bismuth, 0.6 wt.% copper, 4.1 wt.% antimony, 0.03 wt.% nickel, 0.006 wt.% silicon, and the balance tin together with unavoidable impurities.

In a reference example, the alloy comprises 3 to 4 wt.% silver, 2.5 to 3.5 wt.% bismuth, 0.5 to 0.8 wt.% copper, 0.02 to 0.1 wt.% nickel, 0.01 to 0.03 wt.% iron, and the balance tin together with unavoidable impurities. Such an alloy has a melting range from 214.4 to 226.7 °C. In one specific example of this reference example, the alloy comprises approximately, 3.6 wt.% silver, 3 wt.% bismuth, 0.6 wt.% copper, 3.9 wt.% antimony, 0.05 wt.% nickel, 0.03 wt.% iron, and the balance tin together with unavoidable impurities.

In a reference example, the alloy comprises 2.5 to 3.5 wt.% silver, 2.5 to 3.5 wt.% bismuth, 0.4 to 0.6 wt.% copper, 5 to 6 wt.% indium, 1 to 2 wt.% antimony, 0.02 to 0.08 wt.% nickel, and the balance tin together with unavoidable impurities. Such an alloy has a melting range from 195.1 to 211.8 °C. In one specific example of this reference example, the alloy comprises approximately, 3 wt.% silver, 3.2 wt.% bismuth, 0.5 wt.% copper, 6 wt.% indium, 1.6 wt.% antimony, 0.06 wt.% nickel, and the balance tin together with unavoidable impurities.

In a reference example, the alloy comprises 3 to 4 wt.% silver, 3 to 4 wt.% bismuth, 0.5 to 0.7 wt.% copper, 3 to 4 wt.% antimony, 0.02 to 0.1 wt.% nickel, 0.02 to 0.08 wt.% cobalt, and the balance tin together with unavoidable impurities. Such an alloy has a melting range from 209.6 to 224.9 °C. In one specific example of this reference example, the alloy comprises approximately, 3.4 wt.% silver, 3.6 wt.% bismuth, 0.6 wt.% copper, 3.6 wt.% antimony, 0.05 wt.% nickel, 0.06 wt.% cobalt, and the balance tin together with unavoidable impurities.

In a reference example, the alloy comprises 2.5 to 3.5 wt.% silver, 3 to 4 wt.% bismuth, 0.5 to 0.7 wt.% copper, 3 to 4 wt.% antimony, 0.03 to 0.1 wt.% cobalt, 0.001 to 0.005 wt.% manganese, and the balance tin together with unavoidable impurities. Such an alloy has a melting range from 210 to 225.3 °C. In one specific example of this reference example, the alloy comprises approximately, 3 wt.% silver, 3.6 wt.% bismuth, 0.7 wt.% copper, 3.9 wt.% antimony, 0.05 wt.% cobalt, 0.002 wt.% manganese, and the balance tin together with unavoidable impurities.

In a reference example, the alloy comprises 3 to 4 wt.% silver, 3 to 4 wt.% bismuth, 0.5 to 0.7 wt.% copper, 3.5 to 4.5 wt.% antimony, 0.002 to 0.01 wt.% manganese. Such an alloy has a melting range from 213.9 to 224.6 °C. In one specific example of this reference example, the alloy comprises approximately, 3.5 wt.% silver, 3.1 wt.% bismuth, 0.7 wt.% copper, 4 wt.% antimony, 0.006 wt.% manganese, and the balance tin together with unavoidable impurities.

In a reference example, the alloy comprises 3 to 4 wt.% silver, 3 to 4 wt.% bismuth, 0.5 to 0.7 wt.% copper, 3.5 to 4.5 wt.% antimony, 0.001 to 0.005 wt.% manganese, 0.01 to 0.1 wt.% iron, and the balance tin together with unavoidable impurities. Such an alloy has a melting range from 214.7 to 224.6 °C. In one specific example of this reference example, the alloy comprises approximately 3.5 wt.% silver, 3.1 wt.% bismuth, 0.7 wt.% copper, 4 wt.% antimony, 0.003 wt.% manganese, 0.09 wt.% iron, and the balance tin together with unavoidable impurities.

In a reference example, the alloy comprises 3 to 4 wt.% silver, 3 to 4 wt.% bismuth, 0.5 to 0.7 wt.% copper, 3.5 to 4.5 wt.% antimony, 0.01 to 0.1 wt.% nickel, 0.01 to 0.1 wt.% cobalt, 0.005 to 0.015 wt.% germanium, and the balance tin together with unavoidable impurities. Such an alloy has a melting range from 215 to 225.7 °C. In one specific example of this reference example, the alloy comprises approximately 3.5 wt.% silver, 3.1 wt.% bismuth, 0.7 wt.% copper, 4 wt.% antimony, 0.05 wt.% nickel, 0.05 wt.% cobalt, 0.01 wt.% germanium, and the balance tin together with unavoidable impurities.

In a reference example, the alloy comprises 2.5 to 3.5 wt.% silver, 3 to 4 wt.% bismuth, 0.5 to 0.7 wt.% copper, 4.5 to 5.5 wt.% antimony, 0.02 to 0.07 wt.% cobalt, 0.01 to 0.05 wt.% titanium, and the balance tin together with unavoidable impurities. Such an alloy has a melting range from 213.8 to 228.5 °C. In one specific example of this reference example, the alloy comprises approximately, 3 wt.% silver, 3.1 wt.% bismuth, 0.6 wt.% copper, 5 wt.% antimony, 0.06 wt.% cobalt, 0.04 wt.% titanium, and the balance tin together with unavoidable impurities.

In a reference example, the alloy comprises 3 to 4 wt.% silver, 0.02 to 0.1 wt.% bismuth, 0.5 to 0.7 wt.% copper, 4.5 to 5.5 wt.% antimony, 0.1 to 1 wt.% gallium, and the balance tin together with unavoidable impurities. Such an alloy has a melting range from 221.9 to 229.3 °C. In one specific example of this reference example, the alloy comprises approximately, 3.7 wt.% silver, 0.08 wt.% bismuth, 0.6 wt.% copper, 5.2 wt.% antimony, 0.05 wt.% nickel, 0.5 wt.% gallium, and the balance tin together with unavoidable impurities.

In a reference example, the alloy comprises 3 to 4 wt.% silver, 0.01 to 0.1 wt.% bismuth, 0.5 to 0.7 wt.% copper, 0.4 to 0.7 wt.% indium, 4.5 to 5.5 wt.% antimony, 0.02 to 0.08 wt.% cobalt, and the balance tin together with unavoidable impurities. Such an alloy has a melting range from 221.6 to 229.7 °C. In one specific example of this reference example, the alloy comprises approximately 3.7 wt.% silver, 0.07 wt.% bismuth, 0.6 wt.% copper, 0.6 wt.% indium, 5.2 wt.% antimony, 0.06 wt.% cobalt, and the balance tin together with unavoidable impurities.

In a reference example, the alloy comprises 3 to 4 wt.% silver, 0.5 to 2 wt.% bismuth, 0.5 to 0.7 wt.% copper, 3.5 to 4.5 wt.% antimony, and the balance tin together with unavoidable impurities. Such an alloy has a melting range from 219.1 to 227.5 °C. In one specific example of this reference example, the alloy comprises approximately 3.7 wt.% silver, 1.1 wt.% bismuth, 0.6 wt.% copper, 4 wt.% antimony, and the balance tin together with unavoidable impurities.

In a reference example, the alloy comprises 3 to 4 wt.% silver, 2.5 to 3.5 wt.% bismuth, 0.5 to 0.7 wt.% copper, 3 to 4 wt.% antimony, and the balance tin together with unavoidable impurities. Such an alloy has a melting range from 216.2 to 226.9 °C. In one specific example of this reference example, the alloy comprises approximately 3.7 wt.% silver, 2.1 wt.% bismuth, 0.6 wt.% copper, 3.9 wt.% antimony, and the balance tin together with unavoidable impurities.

In a reference example, the alloy comprises 3 to 4 wt.% silver, 3 to 4 wt.% bismuth, 0.5 to 0.7 wt.% copper, 3 to 4 wt.% antimony, and the balance tin together with unavoidable impurities. Such an alloy has a melting range from 212.5 to 224.8 °C. In one specific example of this reference example, the alloy comprises approximately 3.8 wt.% silver, 3.2 wt.% bismuth, 0.7 wt.% copper, 3.6 wt.% antimony, and the balance tin together with unavoidable impurities.

In a reference example, the alloy comprises 3 to 4 wt.% silver, 3.5 to 4.5 wt.% bismuth, 0.5 to 0.7 wt.% copper, 3 to 4 wt.% antimony, and the balance tin together with unavoidable impurities. Such an alloy has a melting range from 210.7 to 223.9 °C. In one specific example of this reference example, the alloy comprises approximately 3.5 wt.% silver, 4 wt.% bismuth, 0.6 wt.% copper, 3.6 wt.% antimony, and the balance tin together with unavoidable impurities.

In a reference example, the alloy comprises 3 to 4 wt.% silver, 4.5 to 5.5 wt.% bismuth, 0.4 to 0.6 wt.% copper, 3 to 4 wt.% antimony, and the balance tin together with unavoidable impurities. Such an alloy has a melting range from 209.5 to 222.7 °C. In one specific example of this reference example, the alloy comprises approximately 3.1 wt.% silver, 5.1 wt.% bismuth, 0.5 wt.% copper, 3.7 wt.% antimony, and the balance tin together with unavoidable impurities.

In a reference example, the alloy comprises 3 to 4 wt.% silver, 5.5 to 6.5 wt.% bismuth, 0.4 to 0.7 wt.% copper, 3 to 4 wt.% antimony, and the balance tin together with unavoidable impurities. Such an alloy has a melting range from 206.2 to 220.8 °C. In one specific example of this reference example, the alloy comprises approximately 3.2 wt.% silver, 6 wt.% bismuth, 0.5 wt.% copper, 3.2 wt.% antimony, and the balance tin together with unavoidable impurities.

A reference example provides a lead-free solder alloy comprising:
(a) 2.5 to 5 wt.% of silver
(b) 0.01 to 5 wt.% of bismuth
(c) 1.0 to 7.0 wt.% of antimony
(d) 0.01 to 2.0 wt.% of copper
(e) At least one of the following elements
   Up to 0.5 wt.% nickel
   Up to 0.5 wt.% titanium
   Up to 0.5 wt.% germanium
   Up to 5.0 wt.% indium
   Up to 0.5 wt.% manganese
   Up to 0.5 wt.% rare earths, like neodymium, cerium, lanthanum.
   Up to 5.0 wt.% aluminium
   Up to 5.0 wt.% silicon
(f) Optionally one or more of the following elements
   0 to 0.5 wt.% chromium
   0 to 0.5 wt.% iron
   0 to 0.5 wt.% phosphorus
   0 to 0.5 wt.% gold
   0 to 0.5 wt.% gallium
   0 to 0.5 wt.% tellurium
   0 to 0.5 wt.% selenium
   0 to 0.5 wt.% calcium
   0 to 0.5 wt.% vanadium
   0 to 0.5 wt.% molybdenum
   0 to 0.5 wt.% platinum
   0 to 0.5 wt.% magnesium
(g) The balance tin, together with any unavoidable impurities.

A reference example provides a soldered joint comprising a solder alloy as described herein.

In a further aspect, the present invention provides a solder paste comprising:
the solder alloy of the present invention, and
a solder flux.

In a further aspect, the present invention provides a method of forming a solder joint comprising:
(i) providing two or more work pieces to be joined;
(ii) providing a solder alloy of the present invention or a solder paste of the present invention; and
(iii) heating the solder alloy or solder paste in the vicinity of the work pieces to be joined.

The work pieces may be components of a printed circuit board, such as a substrate and a die.

In a further aspect, the present invention provides use of a solder alloy of the present invention or the solder paste of the present invention in a soldering method.

The soldering method is preferably selected from wave soldering, Surface Mount Technology (SMT) soldering, die attach soldering, thermal interface soldering, hand soldering, laser and RF induction soldering, soldering to a solar module, soldering of level 2 LED package-board, solder dipping, and rework soldering.

In a further aspect, the present invention provides a method of manufacturing the solder alloy of the present invention, the method comprising:
providing the recited elements, and
melting the recited elements,
wherein the recited elements may be provided in the form of individual elements and/or in the form of one or more alloys containing one of more of the recited elements.

The present invention will now be described further with reference to the following non-limiting examples.

### Example 1 - Alloy 1 (Reference Example)

Alloy 1 comprises 3 wt.% silver, 3.1 wt.% bismuth, 2.1 wt.% antimony, 0.8 wt.% copper, 3.3 wt.% indium, 0.2 wt.% nickel, and the balance tin together with unavoidable impurities. Alloy 1 has a melting range of 202.8 to 217.9°C; and a Vickers Hardness of 28.6 Hv.

### Example 1a - Alloy 1a (Reference Example)

Alloy 1a contains 3.8 wt.% silver, 3 wt.% bismuth, 1.4 wt.% antimony, 0.7 wt.% copper, 0.15 wt.% nickel, and the balance tin together with unavoidable impurities.

### Example 1b - Alloy 1b (Reference Example)

Alloy 1b contains 3.3 wt.% silver, 3.2 wt.% bismuth, 3 wt.% antimony, 0.7 wt.% copper, 0.04 wt.% nickel, 0.01 wt.% cobalt, and the balance tin together with unavoidable impurities.

### Example 2 - Alloy 2 (Reference Example)

Alloy 2 comprises 3 wt.% silver, 3.1 wt.% bismuth, 2.1 wt.% antimony, 0.7 wt.% copper, 0.2 wt.% nickel, 1.2 wt.% indium, and the balance tin together with unavoidable impurities. Alloy 2 has a melting range of 209.7 to 223.5°C; and a Vickers Hardness of 27.2 Hv.

### Example 3 - Alloy 3 (Reference Example)

Alloy 3 comprises 3.6 wt.% silver, 3.9 wt.% bismuth, 0.7 wt.% copper, 4 wt.% antimony, 0.09 wt.% nickel,0.001 wt.% manganese, and the balance tin together with unavoidable impurities. Alloy 3 has a melting range of 203.3 to 236.1°C.

### Example 4 - Alloy 4 (Reference Example)

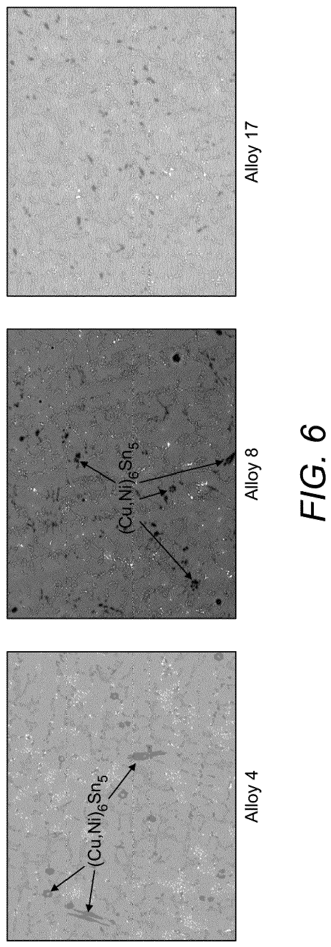

Alloy 4 comprises 3.5 wt.% silver, 4.1 wt.% bismuth, 6.1 wt.% antimony, 0.7 wt.% copper, 0.1 wt.% nickel, 0.004 wt.% manganese, and the balance tin together with unavoidable impurities. Alloy 4 has a melting range of 197.4 to 231.6 °C. A cross-section of the as-cast microstructure of this alloy shown in Figure 6 reveals a distribution of Ag₃Sn in the tin matrix. Bigger precipitates of (Cu,Ni)₆Sn₅ and some fine precipitates tin-bismuth intermetallic are also observed. Such a microstructure is an example of solid solution and precipitation strengthening, which contribute for alloy strengthening and its improved mechanical properties.

### Example 7 - Alloy 7 (Reference Example)

Alloy 7 comprises of 3.2 wt.% silver, 3.4 wt.% bismuth, 0.5 wt.% copper, 3.9 wt.% antimony, 0.16 wt.% nickel, 0.001 wt.% germanium, and the balance tin together with any unavoidable impurities. The melting range of this alloy is 211.4 to 225.5 °C.

### Example 8 - Alloy 8 (Reference Example)

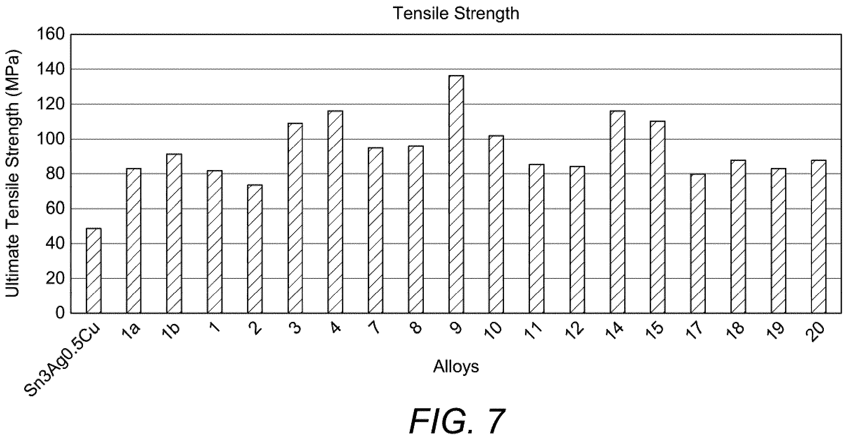

Alloy 8 comprises of 3.2 wt.% silver, 3 wt.% bismuth, 0.5 wt.% copper, 4.9 wt.% antimony, 0.16 wt.% nickel, 0.001 wt.% germanium, and the balance tin together with any unavoidable impurities. The melting range of this alloy is 215.2 to 228.3 °C. The bulk microstructure of this alloy shown in Figure 6 consists of eutectic network of Ag₃Sn along with Bi-Sn (white) and (Cu,Ni)₆Sn₅ precipitates (dark particles). Some of the (Cu,Ni)₆Sn₅ precipitates tend to form floret-like structure. Such a morphology of the precipitates suggests that the alloy will have improved mechanical properties as shown in Figures 7, 8 and 9.

### Example 9 - Alloy 9 (Reference Example)

Alloy 9 comprise 3.5 wt.% silver, 3.7 wt.% bismuth, 0.5 wt.% copper, 3.4 wt.% indium, 6.1 wt.% antimony, 0.06 wt.% nickel, 0.002 wt.% neodymium, and the balance tin together with unavoidable impurities. The melting range of this alloy is from 186.9 to 232.9 °C.

### Example 10 - Alloy 10 (Reference Example)

Alloy 10 comprises 3.2 wt.% silver, 3 wt.% bismuth, 0.5 wt.% copper, 5.9 wt.% antimony, 0.16 wt.% nickel, 0.006 wt.% titanium, and the balance tin together with any unavoidable impurities. The bulk microstructure of this alloy consists of a well-dispersed eutectic network of Ag₃Sn, Bi-Sn and Cu₆Sn₅ precipitates. This alloy has a melting range of 202.5 to 234.5 °C.

### Example 11 - Alloy 11 (Reference Example)

Alloy 11 comprises 3.1 wt.% silver, 3.1 wt.% bismuth, 0.7 wt.% copper, 1.1 wt.% indium, 6.1 wt.% antimony, 0.25 wt.% nickel, and the balance tin together with any unavoidable impurities. Alloy 11 has a melting range of 214.3 to 228.4 °C. The hardness of this alloy is 32.4 Hv.

### Example 12 - Alloy 12 (Reference Example)

Alloy 12 comprises 3.5 wt.% silver, 3.5 wt.% bismuth,0.7 wt.% copper, 6.2 wt.% antimony, 0.3 wt.% nickel, 0.001 wt.% cerium, and the balance tin together with unavoidable impurities. The melting range of this alloy is 213.9 to 230.4 °C. The hardness of this alloy is 28 Hv.

### Example 13 - Alloy 13 (Reference Example)

Alloy 13 comprises 3.5 wt.% silver, 3.7 wt.% bismuth, 0.5 wt.% copper,3.4 wt.% indium,6.1 wt.% antimony, and the balance tin together with unavoidable impurities. This alloy has a melting range from 195.3 to 229.3 °C.

### Example 14 - Alloy 14 (Reference Example)

Alloy 14 comprises 3.5 wt.% silver, 3.8 wt.% bismuth, 0.5 wt.% copper, 3.4 wt.% indium, 6.18 wt.% antimony, 0.006 wt.% titanium, 0.001 wt.% germanium, and the balance tin together with any unavoidable impurities. The melting range of this alloy is from 186.5 to 232.5 °C.

### Example 15 - Alloy 15 (Reference Example)

Alloy 15 comprises 3.6 wt.% silver, 3.9 wt.% bismuth, 0.7 wt.% copper, 3.9 wt.% antimony, 0.09 wt.% nickel, 0.001 wt.% germanium, and the balance tin together with any unavoidable impurities. The alloy has a melting range from 198.9 to 230.9 °C.

### Example 16 - Alloy 16 (Reference Example)

Alloy 16 comprises 3.5 wt.% silver, 3.2 wt.% bismuth, 0.7 wt.% copper, 3.2 wt.% antimony, 0.05 wt.% nickel, and the balance tin together with any unavoidable impurities.

### Example 17 - Alloy 17 (Reference Example)

Alloy 17 comprises of 3 wt.% silver, 3.2 wt.% bismuth, 0.7 wt.% copper, 3.5 wt.% antimony, 0.06 wt.% nickel, 0.02 wt.% titanium, and the balance tin together with any unavoidable impurities. Alloy 17 has a melting range from 198.9 to 227.6 °C. The bulk microstructure of this alloy is shown in figure 6. A fine network of Ag₃Sn with well-distributed (Cu, Ni)₆Sn₅ and bismuth-tin precipitates are clearly visible.

### Example 18 - Alloy 18 (Reference Example)

Alloy 18 comprises 3 wt.% silver, 3.2 wt.% bismuth, 0.5 wt.% copper, 6.1 wt.% antimony, 0.03 wt.% nickel, 0.02 wt.% titanium, and the balance tin together with any unavoidable impurities.

### Example 19 - Alloy 19 (Reference Example)

Alloy 19 comprises 3 wt.% silver, 3.2 wt.% bismuth, 0.5 wt.% copper, 6.1 wt.% antimony, 0.01 wt.% nickel, 0.03 wt.% titanium, and the balance tin together with unavoidable impurities. The melting range of alloy 19 is from 203.3 to 229.7 °C.

### Example 20 - Alloy 20 (Reference Example)

Alloy 20 comprises of 3.4 wt.% silver, 3.4 wt.% bismuth, 0.7 wt.% copper, 3.4 wt.% antimony, 0.002 wt.% titanium, 0.007 wt.% germanium, and the balance tin together with any unavoidable impurities. Alloy 20 has a melting range of 203.8 to 226.5 °C.

### Example 21 - Alloy 21 (Reference Example)

Alloy 21 comprises of 3 wt.% silver, 3.1 wt.% bismuth, 0.7 wt.% copper, 5.1 wt.% antimony, 0.14 wt.% nickel, 0.04 wt.% titanium, 0.001 wt.% germanium, and the balance tin together with any unavoidable impurities.

### Example 22 - Alloy 22

Alloy 22 comprises of 3.5 wt.% silver, 3.1 wt.% bismuth, 0.7 wt.% copper, 3.8 wt.% antimony, 0.005 wt.% neodymium, and the balance tin together with any unavoidable impurities. Alloy 22 has a melting range of 210.8 to 224.5 °C.

### Example 23 - Alloy 23 (Reference Example)

Alloy 23 comprises of 3.5 wt.% silver, 4.2 wt.% bismuth, 0.5 wt.% copper, 3.9 wt.% antimony, 0.06 wt.% nickel, 0.001 wt.% germanium, and the balance tin together with any unavoidable impurities.

### Example 24 - Alloy 24 (Reference Example)

Alloy 24 comprises 3.8 wt.% silver, 4.2 wt.% bismuth, 0.5 wt.% copper, 3.2 wt.% indium, 4.7 wt.% antimony, and the balance tin together with any unavoidable impurities. Alloy 24 has melting range of 195.8 to 228.6 °C.

### Example 25 - Alloy 25 (Reference Example)

Alloy 25 comprises 3.8 wt.% silver, 4.2 wt.% bismuth, 0.5 wt.% copper, 3.3 wt.% indium, 4.6 wt.% antimony, 0.001 germanium, and the balance tin together with any unavoidable impurities. The melting range of alloy 25 is 194.5 to 220.3 °C.

### Example 26 - Alloy 26 (Reference Example)

Alloy 26 comprises 3.8 wt.% silver, 1.6 wt.% bismuth, 1.3 wt.% copper, 4 wt.% antimony, 0.015 wt.% aluminium, 0.007 wt.% silicon, and the balance tin together with any unavoidable impurities. The melting range of alloy 26 is from 217.5 to 227.1 °C.

### Example 27 - Alloy 27 (Reference Example)

Alloy 27 comprises 3.4 wt.% silver, 3.3 wt.% bismuth, 0.6 wt.% copper, 3.4 wt.% antimony, 0.05 wt.% nickel, 0.001 wt.% neodymium, and the balance tin together with any unavoidable impurities. The melting range of this alloy is 212.8 to 224.5 °C.

### Example 28 - Alloy 29 (Reference Example)

Alloy 29 comprises 3.4 wt.% silver, 4.1 wt.% bismuth,0.7 wt.% copper, 2.1 wt.% antimony, 0.2 wt.% nickel, 0.02 wt.% iron, and the balance tin together with unavoidable impurities.

### Example 29 - Alloy 31 (Reference Example)

Alloy 31 comprises 3.8 wt.% silver, 0.06 wt.% bismuth,0.6 wt.% copper, 0.6 wt.% indium, 5.3 wt.% antimony, 0.06 wt.% nickel, and the balance tin together with unavoidable impurities. This alloy has a melting range from 222.6 to 232.3 °C. The creep strength of alloy 31 is seven times that of 96.5Sn3.0Ag0.5Cu.

### Example 30 - Alloy 32 (Reference Example)

Alloy 32 comprises 3.5 wt.% silver, 3.1 wt.% bismuth, 0.6 wt.% copper, 4.1 wt.% antimony, 0.03 wt.% nickel, 0.006 wt.% silicon, and the balance tin together with unavoidable impurities. This alloy has a melting range from 214.4 to 225.6 °C.

### Example 31 - Alloy 33 (Reference Example)

Alloy 33 comprises 3.6 wt.% silver, 3 wt.% bismuth, 0.6 wt.% copper, 3.9 wt.% antimony, 0.05 wt.% nickel, 0.03 wt.% iron, and the balance tin together with unavoidable impurities. This alloy has a melting range from 214.4 to 226.7 °C.

### Example 32 - Alloy 34 (Reference Example)

Alloy 34 comprises 3 wt.% silver, 3.2 wt.% bismuth,0.5 wt.% copper, 6.3 wt.% indium, 1.6 wt.% antimony, 0.06 wt.% nickel, and the balance tin together with unavoidable impurities. This alloy has a melting range from 195.1 to 211.8 °C.

### Example 33 - Alloy 36 (Reference Example)

Alloy 36 comprises 3.8 wt.% silver, 4 wt.% bismuth, 0.7 wt.% copper, 2 wt.% antimony, 0.03 wt.% nickel, and the balance tin together with unavoidable impurities. Alloy 36 has a melting range from 208.9 to 221.9 °C.

### Example 34 - Alloy 37 (Reference Example)

Alloy 37 comprises 3.4 wt.% silver, 3.6 wt.% bismuth, 0.6 wt.% copper, 3.6 wt.% antimony, 0.05 wt.% nickel, 0.06 wt.% cobalt and the balance tin together with unavoidable impurities. The melting range of this alloy is from 209.6 to 224.9 °C.

### Example 35 - Alloy 38 (Reference Example)

Alloy 38 comprises 3 wt.% silver, 3.6 wt.% bismuth, 0.7 wt.% copper, 3.9 wt.% antimony,0.05 wt.% cobalt, 0.002 wt.% manganese, and the balance tin together with unavoidable impurities. This alloy has a melting range from 210 to 225.3 °C.

### Example 36 - Alloy 39 (Reference Example)

Alloy 39 comprises 3.5 wt.% silver, 3.1 wt.% bismuth, 0.7 wt.% copper, 4 wt.% antimony, 0.006 wt.% manganese, and the balance tin together with unavoidable impurities. Alloy 39 has a melting range from 213.9 to 224.6 °C.

### Example 37 - Alloy 40 (Reference Example)

Alloy 40 comprises 3.5 wt.% silver, 3.1 wt.% bismuth, 0.7 wt.% copper, 4 wt.% antimony, 0.003 wt.% manganese, 0.09 wt.% iron, and the balance tin together with unavoidable impurities. This alloy has a melting range from 214.7 to 224.6 °C.

### Example 38 - Alloy 41 (Reference Example)

Alloy 41 comprises 3.5 wt.% silver, 3.1 wt.% bismuth, 0.7 wt.% copper, 4 wt.% antimony, 0.05 wt.% nickel, 0.05 wt.% cobalt, 0.01 wt.% germanium, and the balance tin together with unavoidable impurities. The melting range of alloy 41 is from 215.0 to 225.7 °C.

### Example 39 - Alloy 42 (Reference Example)

Alloy 42 comprises 3 wt.% silver, 3.1 wt.% bismuth, 0.6 wt.% copper, 5 wt.% antimony, 0.06 wt.% cobalt, 0.04 wt.% titanium, and the balance tin together with unavoidable impurities. This alloy has a melting range from 213.8 to 228.5 °C.

### Example 40 - Alloy 43 (Reference Example)

Alloy 43 comprises 3.7 wt.% silver, 0.08 wt.% bismuth, 0.6 wt.% copper, 5.2 wt.% antimony, 0.05 wt.% nickel, 0.5 wt.% gallium, and the balance tin together with unavoidable impurities. Alloy 43 has a melting range from 221.9 to 229.3 °C.

### Example 41 - Alloy 45 (Reference Example)

Alloy 45 comprises 3.7 wt.% silver, 0.07 wt.% bismuth, 0.6 wt.% copper, 0.6 wt.% indium, 5.2 wt.% antimony, 0.06 wt.% cobalt, and the balance tin together with unavoidable impurities. The melting range of this alloy is from 221.6 to 229.7 °C.

### Example 42 - Alloy 56 (Reference Example)

Alloy 56 comprises 3.7 wt.% silver, 1.1 wt.% bismuth, 0.6 wt.% copper, 4 wt.% antimony, and the balance tin together with unavoidable impurities. This alloy has a melting range from 219.1 to 227.5 °C. This alloy has a hardness of 27.7 Hv.

### Example 43 - Alloy 57 (Reference Example)

Alloy 57 comprises 3.7 wt.% silver, 2.1 wt.% bismuth, 0.6 wt.% copper, 3.9 wt.% antimony, and the balance tin together with unavoidable impurities. The melting range of this alloy is from 216.2 to 226.9 °C. The alloy has a hardness of 28.6 Hv.

### Example 44 - Alloy 58 (Reference Example)

Alloy 58 comprises 3.8 wt.% silver, 3.2 wt.% bismuth, 0.7 wt.% copper, 3.6 wt.% antimony, and the balance tin together with unavoidable impurities. This alloy has a melting range from 212.5 to 224.8 °C. The hardness of the alloy is 30.8 Hv.

### Example 45 - Alloy 59 (Reference Example)

Alloy 59 comprises 3.5 wt.% silver, 4 wt.% bismuth, 0.6 wt.% copper, 3.6 wt.% antimony, and the balance tin together with unavoidable impurities.

The alloy has a melting range from 210.7 to 223.9 °C and a hardness of 30.8 Hv.

### Example 46 - Alloy 60 (Reference Example)

Alloy 60 comprises 3.1 wt.% silver, 5.1 wt.% bismuth, 0.5 wt.% copper, 3.7 wt.% antimony, and the balance tin together with unavoidable impurities. The melting range of this alloy is from 209.5 to 222.7 °C and it has a hardness of 32.2 Hv.

### Example 47 - Alloy 61 (Reference Example)

Alloy 61 comprises 3.2 wt.% silver, 6 wt.% bismuth, 0.5 wt.% copper, 3.2 wt.% antimony, and the balance tin together with unavoidable impurities. This alloy has a melting range from 206.2 to 220.8 °C and it has a hardness of 32.2 Hv.

A summary of the melting range of all the alloys are listed in Table 1.

**Table 1: Melting range of the alloys.**

| **Alloys** | **Melting Range (⁰C)** |
|---|---|
| 96.5Sn3.0Ag0.5Cu | 216.6 - 219 |
| 1a | 215.4 - 221.9 |
| 1b | 201.5 - 228.5 |
| 1 | 202.8 - 217.9 |
| 2 | 209.7 - 223.5 |
| 3 | 203.3 - 236.1 |
| 4 | 197.4 - 231.6 |
| 7 | 211.4 - 225.5 |
| 8 | 215.2 - 228.3 |
| 9 | 186.9 - 232.9 |
| 10 | 202.5 - 232.5 |
| 11 | 214.3 - 228.4 |
| 12 | 213.9 - 230.4 |
| 13 | 195.3 - 229.3 |
| 14 | 186.5 - 232.5 |
| 15 | 198.9 - 230.9 |
| 17 | 198.9 - 227.6 |
| 18 | 202.6 - 229.2 |
| 19 | 203.3 - 229.7 |
| 20 | 203.8 - 226.5 |
| 22 | 210.8 - 224.5 |
| 23 | 202.9 - 224.6 |
| 24 | 195.8 - 228.6 |
| 25 | 194.5 - 220.3 |
| 26 | 217.5 - 227.1 |
| 27 | 212.8 - 224.5 |
| 29 | 209.9 - 221.2 |
| 31 | 222.6 - 232.3 |
| 32 | 214.4 - 225.6 |
| 34 | 195.1 - 211.8 |
| 36 | 208.9 - 221.9 |
| 37 | 209.6 - 224.9 |
| 38 | 210 - 225.3 |
| 39 | 213.9 - 224.6 |
| 40 | 214.7 - 224.6 |
| 41 | 215 - 225.7 |
| 42 | 213.8 - 228.5 |
| 43 | 221.9 - 229.3 |
| 45 | 221.6 - 229.7 |
| 46 | 197.5 - 209.3 |
| 47 | 200 - 211.3 |
| 48 | 203.7 - 211.9 |
| 49 | 218.4 - 222.5 |
| 50 | 221.4 - 228.3 |
| 51 | 222.7 - 234.2 |
| 52 | 222.7 - 229.8 |
| 53 | 223.3 - 232.6 |
| 54 | 220.4 - 227.4 |
| 55 | 223.8 - 232.6 |
| 56 | 219.1 - 227.5 |
| 57 | 216.2 - 226.9 |
| 58 | 212.5 - 224.8 |
| 59 | 210.7 - 223.9 |
| 60 | 209.5 - 222.7 |
| 61 | 206.2 - 220.8 |

The present invention will now be described further with reference to the following drawings in which:
Figure 1 shows a micrograph of a solder alloy according to a reference example.
Figure 2 shows a plot of solidus and liquidus temperatures for alloys with varying Sb contents.
Figure 3 shows a plot of solidus and liquidus temperatures for alloys with varying Sb and Bi contents.
Figure 4 shows a plot of hardness values for alloys with varying Sb and Cu contents.
Figure 5 shows a plot of hardness values for alloys with varying Sb and Bi contents.
Figure 6 shows micrographs of a number of solder alloys according to reference examples.
Figure 7 shows a plot of ultimate tensile strengths (UTS) of a number of solder alloys according to reference examples_and Sn3Cu0.5Ag.
Figure 8 shows a plot of yield strengths (YS) of a number of solder alloys according to reference examples_and Sn3Cu0.5Ag.
Figure 9 shows a plot of creep strengths at 150 °C and 200 N of a solder alloy according to the present invention, reference examples and Sn3Cu0.5Ag.
Figure 10 shows a plot of creep elongations at 150 °C and 200 N of a solder alloy according to the present invention, reference examples and Sn3Cu0.5Ag
Figure 11 shows a micrograph of a BGA formed using the solder alloy according to the present invention.
Figure 12 shows Weibull distribution plots of BGA228 in-situ monitored failures for a solder alloy according to the present invention and reference examples.

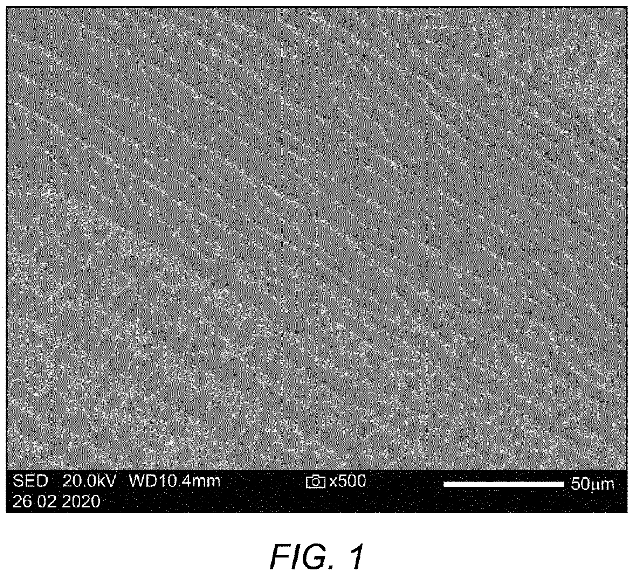

A micrograph of a solder alloy according to a reference example (Sn-5.3Sb-3.8Ag-0.06Bi-0.6Cu-0.6In-0.06Ni) is shown in Figure 1. As can be seen, the solder alloy exhibits a microstructure showing an extensive Ag₃Sn network. As discussed above, such a distributed network of precipitate particles may resist the movement of grain boundaries during creep deformation thus enhancing the creep strength.

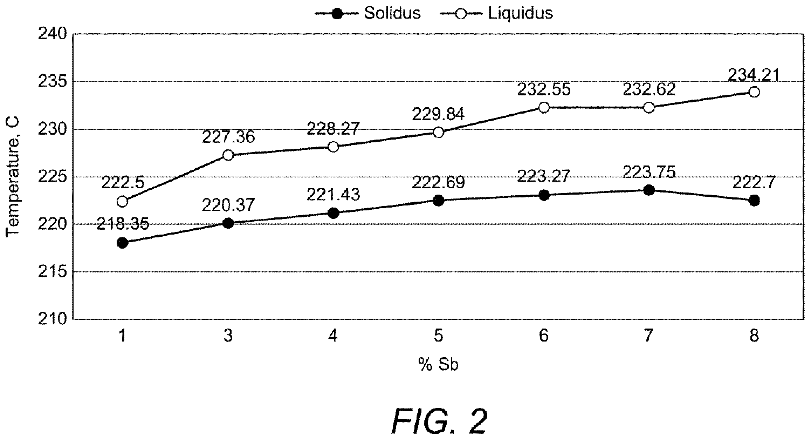

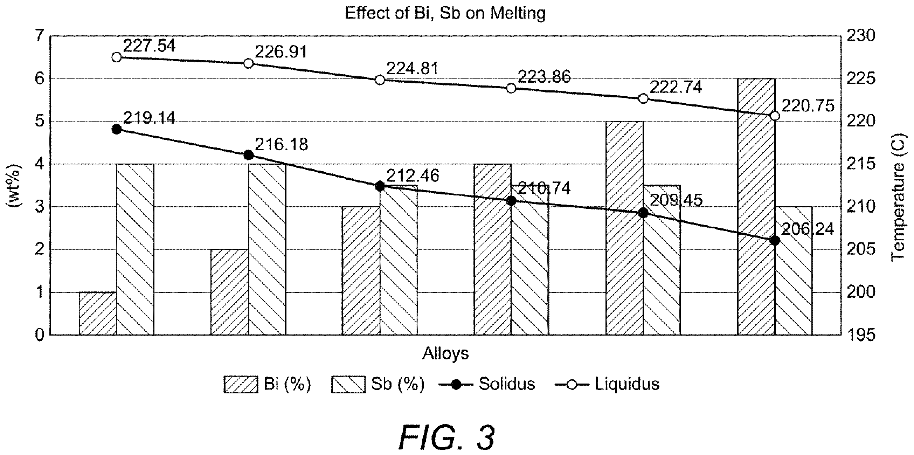

As discussed above, reflow temperatures higher than 260 °C can lead to various issues during soldering, such as damaging printed circuit boards and components. Figures 2 and 3 show the negative effects on the melting behavior of a Sn-Ag-Cu alloy when too much antimony or bismuth is added. As shown in Figure 2, increasing antimony content from 1 to 8 wt.% significantly increases the liquidus temperature while the solidus temperature shows a gradual rise. In this example, when antimony is equal or lower than 7 wt.%, the required reflow temperature will be equal or lower than 260 °C, considering that the peak reflow temperature is 25 to 30 °C above the liquidus temperature. The alloy that is the subject of Figure 2 contains 3.2-3.8 wt.% Ag, 1-8 wt.% Sb, 0.5-0.9 wt.% Cu, balance Sn. In Figure 3 antimony is kept between 3 and 4 wt.%, while increasing the bismuth content. The alloy that is the subject of Figure 3 contains 3.2-3.8 wt.% Ag, 3-4 wt.% Sb, 1-6 wt.% Bi, 0.5-0.7 wt.% Cu, balance Sn. In this example, when bismuth is equal or lower than 5 wt.% its solidus temperature stays above 210 °C, and the solidus-liquidus temperature gap is lower than 10 °C. This is also important as a lower solidus temperature may limit the solder operational temperature and a too large solidus-liquidus temperature gap can lead to soldering defects due to the mushy zone formed before the complete solidification of the solder. As can be seen from Figures 2 and 3, increasing antimony has a greater effect on increasing the liquidus temperature than on the solidus temperature (Figure 2). Decreasing antimony and increasing bismuth decreases both solidus and liquidus temperatures of the alloy (Figure 3).

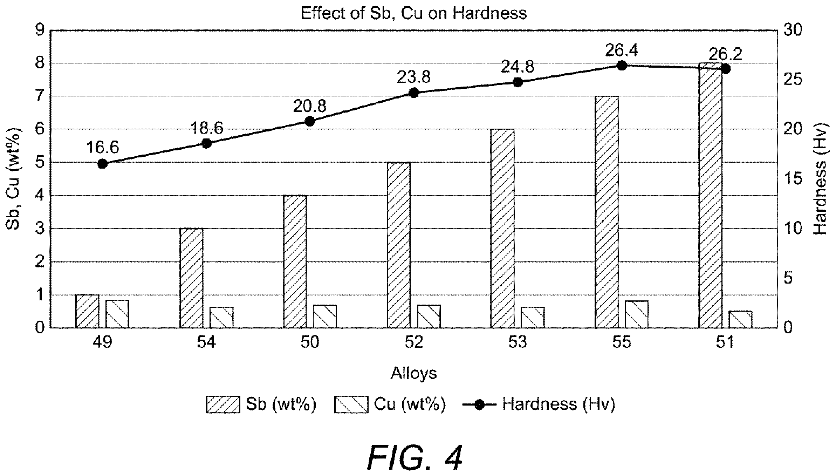

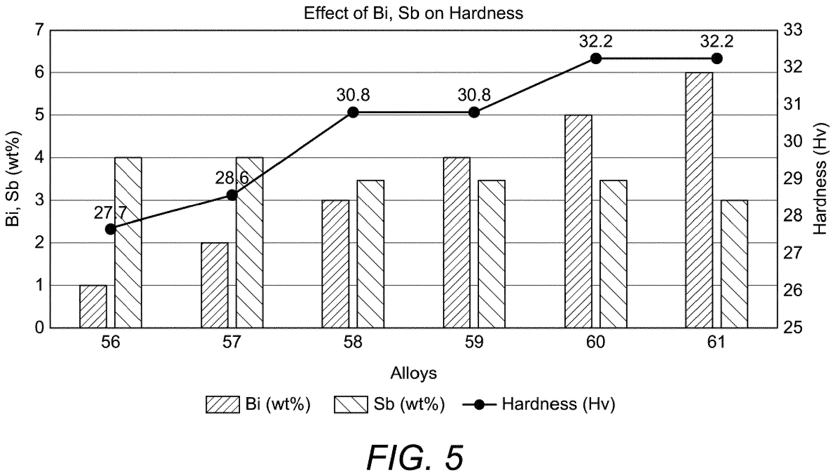

Solid solution strengthening and precipitation hardening caused by various alloying additions leads to increased hardness. For example, antimony significantly contributes to solid solution strengthening whereas copper with very limited solubility in tin forms Cu-Sn intermetallics that also increase the hardness of the alloy. This effect is shown in Figure 4. Bismuth also is a known solid solution strengthening element of tin. The effect of increasing bismuth and slightly decreasing antimony on the hardness of alloys is shown in Figure 5. While increased hardness is often perceived as a negative and undesirable property of solder alloys due to the risk of increased brittleness, hardness can be transformed into a desirable property by means of a balanced alloy design. In this way, hardness can contribute to improved high thermo-mechanical properties of the alloys described herein.

Figure 6 shows the as-cast microstructures of, from left to right, alloys 4, 8 and 17. The precipitates of (Cu,Ni)₆Sn₅ are evenly distributed in the matrix of Ag₃Sn and Sn grains (containing Bi and Sb). The white precipitates are those of Bi-Sn intermetallic particles that form when the solid solubility limit of bismuth in tin is exceeded.

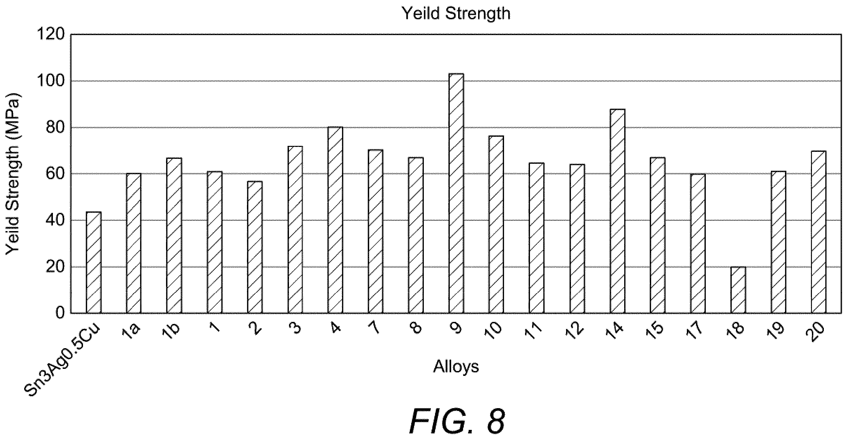

Figures 7 and 8 compares the room temperature tensile properties of a number of the reference example alloys with that of 96.5Sn3.0Ag0.5Cu. There is a remarkable increase in tensile strength compared to 96.5Sn3.0Ag0.5Cu, between 66% and 144%.

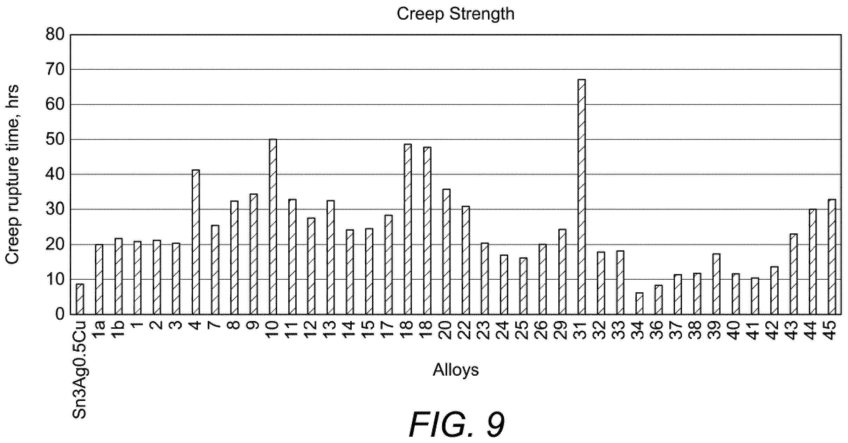

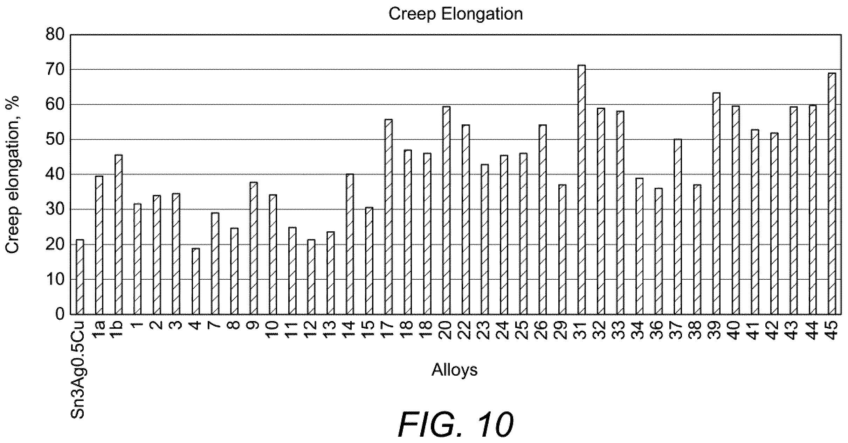

Results from a creep test provide important insight on resistance to creep and creep deformation (elastic and plastic) over a relatively long period of time. In the case of high temperature creep, the phenomenon of microstructure strengthening alternates with the stress relief caused by annealing of the microstructure. High temperature creep properties of an alloy according to the present invention and reference example alloys are graphically presented and compared with that of 96.5Sn3.0Ag0.5Cu in Figures 9 and 10. The alloy of the present invention and the reference example alloys have significantly higher creep strength given by the creep rupture time and the total creep plastic strain. A higher creep rupture time indicates a higher resistance to creep. For example, at 150 °C, the creep rupture time of alloy 8 is 255% higher than that of 96.5Sn3.0Ag0.5Cu.

Diffusion-dependent creep deformation depends on the homologous temperature, i.e. ratio of the test temperature to melting temperature of the material in absolute scale. The homologous temperature of the solder alloy may be in the range of 0.84 to 0.86. The melting temperature of the solder alloy therefore has no significant effect on the mechanical properties.

Table 2 compares the zero-wetting time (T₀) of some of the reference example alloys and an alloy according to the present invention with 96.5Sn3.0Ag0.5Cu, which can be used as a measure of their solderability and wettability. Wetting properties of the alloys are comparable to that of 96.5Sn3.0Ag0.5Cu alloy. This is important as quite often there is degradation in wetting properties of alloys with multiple alloying additions. Wetting tests were performed at 250 °C as per JIS Z 3198-4 standard.

**Table 2: Comparison of zero wetting time of example alloys with 96.5Sn3.0Ag0.5Cu alloy.**

| **Alloys** | **T₀** |
|---|---|
| 96.5Sn3.0Ag0.5Cu | 1.1 |
| 1a | 0.78 |
| Alloy 4 | 1.1 |
| Alloy 8 | 1.3 |
| Alloy 17 | 1.0 |
| Alloy 22 | 0.8 |
| Alloy 27 | 1.0 |

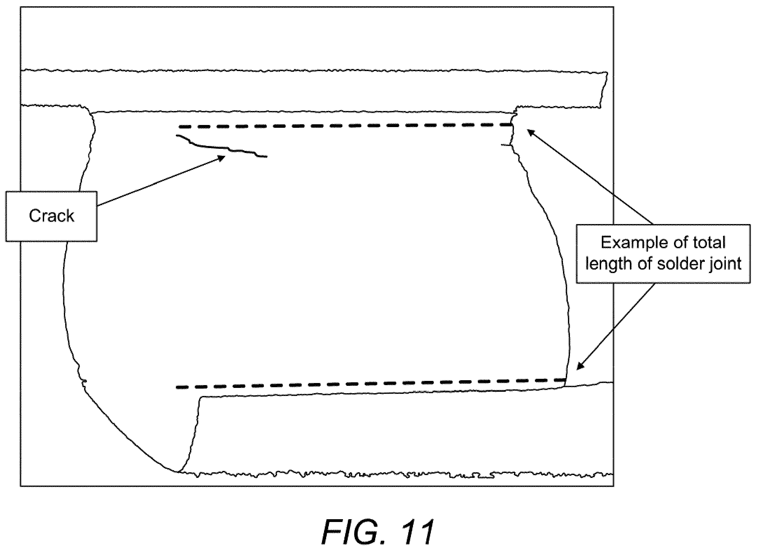

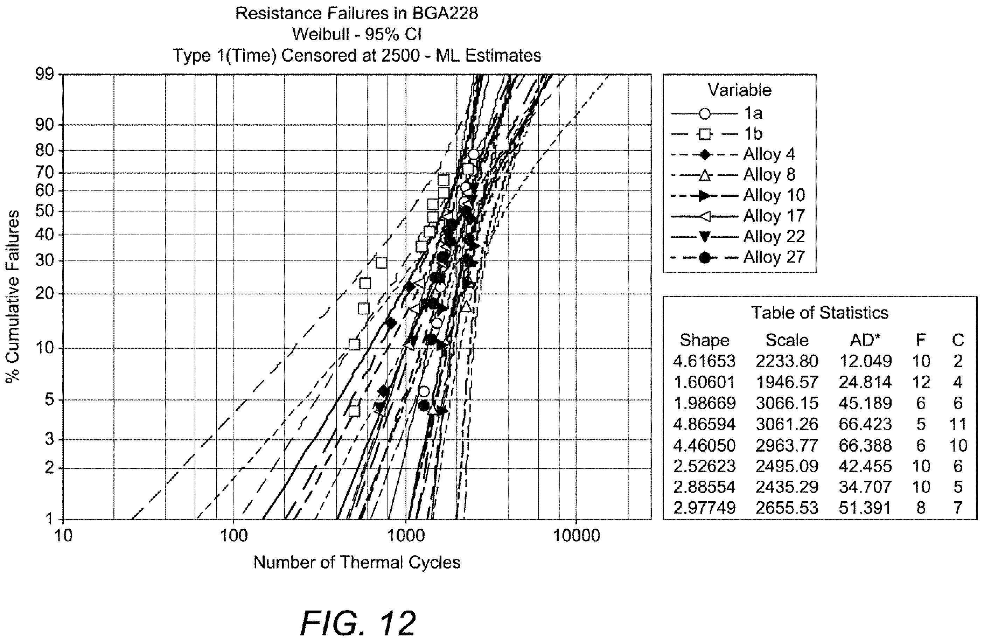

As discussed above, the intermetallic compound formation due to alloying additions in these reference example alloys and the alloy according to the present invention resulted in additional strength of the bulk alloy and the solder joint. Figures 11 and 12 show the results of thermal cycling performance testing. Thermal cycling was performed from -40 to 150 °C, with 30 minutes dwell time at each of these temperatures, in a test conducted as per the IPC 9701A standard. Three key aspects of the solder joints post-thermal cycling test are the in-situ characteristic life, the extension of the cracks in the solder joint, and the percentage of shear strength retained after the thermal cycling test. The thermal cycling characteristic life is given at 63.2 % of cumulative failures of the BGA228 packages when their electrical resistance is monitored in-situ using a high-speed data logger. As per the IPC 9701A standard, a failure is defined when there is an increase of 20% in the measured electrical resistance for five consecutive readings. Figure 11 shows an example of how the total length of solder joint is measured for calculating the crack extension on BGAs. The crack extension is measured as a percentage of the total length of the solder joint. For illustrative purpose, the crack shown here initiates near the solder-IMC interface and extends to an equivalent 23% of the total length of the solder joint. The crack extension in each ball along the outermost row of solder joints in the BGA package has been measured at the end of 2500 cycles. An average of crack extension is measured for each alloy and is summarized in Table 3.

**Table 3: Crack extension after 2500 thermal cycles.**

| Alloys | Average Crack Extension in BGA228 (%) after 2500 thermal cycles |
|---|---|
| 1a | 43.0 |
| 1b | 32.0 |
| Alloy 4 | 17.0 |
| Alloy 8 | 7.0 |
| Alloy 17 | 27.0 |
| Alloy 22 | 23.0 |
| Alloy 27 | 24.0 |

The shear strength retained after thermal aging at 150 °C for 2000 hours is calculated as a fraction of the initial shear strength obtained from as-soldered chip resistors. Table 4 show results for some of these alloys, in which the remainder shear strength is at least 85% of the original solder joint shear strength.

**Table 4: Retained shear strength after thermal ageing of a chip resistor 0805.**

| Alloys | % Retained shear strength after 2000 hours thermal ageing |
|---|---|
| 1a | 95 |
| 1b | 90 |
| Alloy 4 | 88 |
| Alloy 8 | 92 |
| Alloy 17 | 96 |
| Alloy 27 | 85 |

Figure 12 shows Weibull distribution plots of BGA228 in-situ monitored failures for an example alloy according to the present invention and reference examples. All the alloys have a higher characteristic life and a larger number of surviving components. During thermal cycling, the alloys are subjected to thermal stresses leading to creep deformation. Alloys that are capable of resisting creep deformation or accumulating large deformation prior to fracture are expected to have high thermal fatigue life. The higher creep strength of the invented alloys may result in higher thermal fatigue life.

## Claims

1. A lead-free solder alloy comprising:
from 3 to 4 wt.% silver,
from 3 to 4 wt.% bismuth,
from 0.5 to 0.8 wt.% copper,
from 3 to 4 wt.% antimony,
from 0.001 to 0.012 wt.% neodymium,
and the balance tin together with unavoidable impurities in an amount of not more than 1 wt.% in total,
wherein the wt.% of antimony is greater than the wt.% of bismuth.

2. The solder alloy of claim 1 comprising:
3.5 wt.% silver,
3.1 wt.% bismuth,
0.7 wt.% copper,
3.8 wt.% antimony,
0.005 wt.% neodymium,
and the balance tin together with unavoidable impurities.

3. The solder alloy of claim 1 or claim 2 in the form of a bar, a stick, a solid or flux cored wire, a foil or strip, a film, a preform, a powder or paste (powder plus flux blend), solder spheres for use in ball grid array joints, a pre-formed solder piece or a reflowed or solidified solder joint, pre-applied on any solderable material such as a copper ribbon for photovoltaic applications or a printed circuit board of any type.

4. A solder paste comprising:
the solder alloy of claim 1 or claim 2, and
a solder flux.

5. A method of forming a solder joint comprising:
(i) providing two or more work pieces to be joined;
(ii) providing a solder alloy as defined in any of claims 1 to 3 or the solder paste of claim 4; and
(iii) heating the solder alloy or solder paste in the vicinity of the work pieces to be joined.

6. Use of a solder alloy of any of claims 1 to 3 or the solder paste of claim 4 in a soldering method.

7. The use of claim 6, wherein the soldering method is selected from wave soldering, Surface Mount Technology (SMT) soldering, die attach soldering, thermal interface soldering, hand soldering, laser and RF induction soldering, soldering to a solar module, soldering of level 2 LED package-board, solder dipping, and rework soldering.

8. A method of manufacturing the solder alloy of any of claims 1 to 3, the method comprising:
providing the recited elements, and
melting the recited elements,
wherein the recited elements may be provided in the form of individual elements and/or in the form of one or more alloys containing one of more of the recited elements.

## Patentansprüche

1. Bleifreie Lötlegierung, umfassend:
von zu 3 bis 4 Gew.-% Silber,
von zu 3 bis 4 Gew.-% Wismut,
von zu 0,5 bis 0,8 Gew.-% Kupfer,
von zu 3 bis 4 Gew.-% Antimon,
von zu 0,001 bis 0,012 Gew.-% Neodym,
und der Rest Zinn zusammen mit unvermeidbaren Verunreinigungen in einer Menge von insgesamt nicht mehr als 1 Gew.-%,
wobei das Gew.-% von Antimon größer als das Gew.-% von Wismut ist.

2. Lötlegierung nach Anspruch 1, umfassend:
zu 3,5 Gew.-% Silber,
zu 3,1 Gew.-% Wismut,
zu 0,7 Gew.-% Kupfer,
zu 3,8 Gew.-% Antimon,
zu 0,005 Gew.-% Neodym,
und der Rest Zinn zusammen mit unvermeidbaren Verunreinigungen.

3. Lötlegierung nach Anspruch 1 oder 2 in der Form einer Stange, eines Steckens, eines massiven Drahts oder Fülldrahts, einer Folie oder eines Streifens, eines Films, einer Vorform, eines Pulvers oder einer Paste, (einer Mischung aus Pulver plus Flussmittel), Lötkugeln zur Verwendung in Ball-Grid-Array-Verbindungen, eines vorgeformten Lötstücks oder einer aufgeschmolzenen oder erstarrten Lötverbindung, voraufgetragen auf einem beliebigen lötbaren Material, wie einem Kupferband für Fotovoltaikanwendungen oder einer Leiterplatte einer beliebigen Art.

4. Lötpaste, umfassend:
die Lotlegierung nach Anspruch 1 oder 2 und
ein Lötflussmittel.

5. Verfahren zum Ausbilden einer Lötverbindung, umfassend:
(i) Bereitstellen von zwei oder mehr zu verbindenden Werkstücken;
(ii) Bereitstellen einer Lötlegierung, wie in einem der Ansprüche 1 bis 3 definiert, oder der Lötpaste nach Anspruch 4; und
(iii) Erwärmen der Lötlegierung oder Lötpaste in der Nähe der zu verbindenden Werkstücke.

6. Verwendung einer Lotlegierung nach einem der Ansprüche 1 bis 3 oder der Lotpaste nach Anspruch 4 in einem Lötverfahren.

7. Verwendung nach Anspruch 6, wobei das Lötverfahren aus Wellenlöten, Oberflächenmontagetechniklöten (SMT-Löten), Chipbefestigungslöten, Löten thermischer Schnittstellen, Handlöten, Laser- und HF-Induktionslöten, Löten an ein Solarmodul, Löten einer Level 2-LED-Gehäuseplatine, Löttauchen und Nacharbeitslöten ausgewählt ist.

8. Verfahren zum Herstellen der Lötlegierung nach einem der Ansprüche 1 bis 3, das Verfahren umfassend:
Bereitstellen der genannten Elemente und
Schmelzen der genannten Elemente,
wobei die genannten Elemente in der Form einzelner Elemente und/oder in der Form einer oder mehrerer Legierungen, die eines oder mehrere der genannten Elemente enthalten, bereitgestellt werden können.

## Revendications

1. Alliage de brasage sans plomb comprenant :
de 3 à 4 % en poids d'argent,
de 3 à 4 % en poids de bismuth,
de 0,5 à 0,8 % en poids de cuivre,
de 3 à 4 % en poids d'antimoine,
de 0,001 à 0,012 % en poids de néodyme,
et le reste étant de l'étain conjointement avec des impuretés inévitables en une quantité ne dépassant pas 1 % en poids au total,
dans lequel le % en poids d'antimoine est supérieur au % en poids de bismuth.

2. Alliage de brasage selon la revendication 1, comprenant :
3,5 % en poids d'argent,
3,1 % en poids de bismuth,
0,7 % en poids de cuivre,
3,8 % en poids d'antimoine,
0,005 % en poids de néodyme,
et le reste étant de l'étain conjointement avec des impuretés inévitables.

3. Alliage de brasage selon la revendication 1 ou la revendication 2 sous la forme d'une barre, d'un bâtonnet, d'un fil plein ou fourré, d'une feuille ou bande, d'un film, d'une préforme, d'une poudre ou pâte (mélange de poudre et flux), de sphères de brasage pour utilisation dans des joints de boîtiers matriciels à billes, d'une pièce de brasage préformée ou d'un joint de brasage refondu ou solidifié, préappliqué sur tout matériau brasable tel qu'un ruban de cuivre pour des applications photovoltaïques ou une carte de circuit imprimé de tout type.

4. Pâte à braser comprenant :
l'alliage de brasage selon la revendication 1 ou la revendication 2, et
un flux de brasage.

5. Procédé de formation d'un joint à brasure tendre comprenant :
(i) la fourniture de deux pièces de travail à joindre ou plus ;
(ii) la fourniture d'un alliage de brasage selon l'une quelconque des revendications 1 à 3 ou de la pâte à braser selon la revendication 4 ; et
(iii) le chauffage de l'alliage de brasage ou de la pâte à braser au voisinage des pièces de travail à joindre.

6. Utilisation d'un alliage de brasage selon l'une quelconque des revendications 1 à 3 ou de la pâte à braser selon la revendication 4 dans un procédé de brasage.

7. Utilisation selon la revendication 6 dans lequel le procédé de brasage est choisi parmi brasage à la vague, brasage par technologie de montage en surface (SMT), brasage par fixation de matrice, brasage par interface thermique, brasage à la main, brasage par induction laser et RF, brasage sur un module solaire, brasage d'une carte à DEL de niveau 2, brasage par immersion et brasage de retouche.

8. Procédé de fabrication de l'alliage de brasage selon l'une quelconque des revendications 1 à 3, le procédé comprenant :
la fourniture des éléments cités, et
la fusion des éléments cités,
dans lequel les éléments cités peuvent être fournis sous la forme d'éléments individuels et/ou sous la forme d'un ou plusieurs alliages contenant un ou plusieurs des éléments cités.
